(19) **Europäisches Patentamt**
**European Patent Office**
**Office européen des brevets**

(11) **EP 4 199 033 A1**

(12) **EUROPEAN PATENT APPLICATION**

(43) Date of publication:
**21.06.2023 Bulletin 2023/25**

(21) Application number: **21216074.1**

(22) Date of filing: **20.12.2021**

(51) International Patent Classification (IPC):
***H01J 37/28*** (2006.01)       ***H01J 37/302*** (2006.01)
***H01J 37/317*** (2006.01)

(52) Cooperative Patent Classification (CPC):
**H01J 37/28; H01J 37/3026; H01J 37/3177;**
H01J 2237/2811; H01J 2237/31766

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **VAN SOEST, Jurgen
5500 AH Veldhoven (NL)**
• **WIELAND, Marco, Jan-Jaco
5500 AH Veldhoven (NL)**
• **KUIPER, Vincent, Sylvester
5500 AH Veldhoven (NL)**

(74) Representative: **ASML Netherlands B.V.
Corporate Intellectual Property
P.O. Box 324
5500 AH Veldhoven (NL)**

(54) **METHOD OF PROCESSING A SAMPLE WITH A CHARGED PARTICLE ASSESSMENT SYSTEM**

(57)    Methods of processing a sample and charged particle assessment systems are disclosed. In one arrangement, a sample is processed using a multi-beam of sub-beams of charged particles. At least a portion of a sub-beam processable area is processed with each sub-beam. The sub-beam processable area comprising an array of sections having rows of sections and columns of sections. Each row of sections defines an elongate region that is substantially equal to or smaller than a pitch at the sample surface of the sub-beams in the multi-beam. A plurality of the sections are processed.

## Fig. 13

## Description

FIELD

The embodiments disclosed herein relate to processing a sample using a multi-beam of charged particles, particularly in the context of inspecting a sample, for example to identify defects.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection apparatuses with a charged particle beam have been used to inspect objects, which may be referred to as samples, for example to detect pattern defects. These apparatuses typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection apparatus may obtain an image representing characteristics of the material structure of the surface of the sample.

Exposing a sample to a beam of electrons can apply a thermal load to the sample. Such a thermal load may cause distortion in the sample resulting in position errors. There is a general need to alleviate such thermal loads and at least maintain if not improve throughput, position accuracy and other characteristics of charged-particle tools and methods.

SUMMARY

It is an object of the present disclosure to provide embodiments that support improvement of throughput or other characteristics of charged-particle tools.

According to an aspect of the invention, there is provided a method of processing a sample using a multi-beam of sub-beams of charged particles using a charged particle device for projecting the multi-beam onto a sample surface, the method comprising in sequence: (a) move the sample in a direction parallel to a first direction while using the charged particle device to repeatedly move the multi-beam relative to the sample surface in a direction parallel to a second direction, thereby scanning each sub-beam in the direction parallel to the first direction and repeatedly in the direction parallel to the second direction to process a section of one of a plurality of elongate regions on the sample surface with the sub-beam, the distance of movement of the sample in (a) being equal to or less than one half of the pitch at the sample surface of the sub-beams in the multi-beam in the first direction; (b) displace the sample in a direction oblique or perpendicular to the first direction; (c) repeat step (a) to process a section of a further elongate region of the plurality of elongate regions with each sub-beam; (d) repeat steps (b) and (c) multiple times to process sections of further respective elongate regions of the plurality of elongate regions with each sub-beam; and (e) repeat steps (a) to (d) for a series of unprocessed sections of the elongate regions for each sub-beam, the series of unprocessed sections adjoining, in a direction parallel to the movement in step (a), a corresponding series of sections of respective elongate regions previously processed by the sub-beam.

According to an aspect of the invention, there is provided a method of processing a sample using a multi-beam of sub-beams of charged particles using a charged particle device for projecting the multi-beam onto a sample surface, the method comprising: processing at least a portion of a sub-beam processable area with each sub-beam, the sub-beam processable area comprising an array of sections having rows of sections and columns of sections, each row of sections defining an elongate region that is substantially equal to or smaller than a pitch at the sample surface of the sub-beams in the multi-beam, the processing comprising processing a plurality of the sections.

According to an aspect of the invention, there is provided a charged particle assessment system, comprising: a sample support configured to support a sample; a charged particle device configured to project a plurality of sub-beams of charged particles in a multi-beam arrangement onto a portion of a sample surface; a controller configured to control the sample support and the charged particle device to perform the following steps in sequence: (a) move the sample in a direction parallel to a first direction while using the charged particle device to repeatedly move the multi-beam relative to the sample surface in a direction parallel to a second direction, thereby scanning each sub-beam in the direction parallel to the first direction and repeatedly in the direction parallel to the second direction to process a section of one of a plurality of elongate regions on the sample surface with the sub-beam, the distance of movement of the sample in (a) being equal to or less than one half of the pitch at the sample surface of the sub-beams in the multi-beam in the first direction; (b) displace the sample in a direction oblique or perpendicular to the first direction; (c) repeat step (a) to process a section of a further elongate region of the plurality of elongate regions with each sub-beam; (d) repeat steps (b) and (c) multiple times to process sections of further respective elongate regions of the plurality of elongate regions with each sub-beam; and (e) repeat steps (a) to (d) for a series of unprocessed sections of the elongate regions for each sub-beam, the series of unprocessed sections adjoining, in a direction parallel to the movement in step (a), a corresponding series of sections of respective elongate regions previously processed by the sub-beam.

According to an aspect of the invention, there is provided a charged particle assessment system, comprising: a sample support configured to support a sample; a charged particle device configured to project a plurality of sub-beams of charged particles in a multi-beam arrangement onto a portion of a sample surface; and a controller configured to control the sample support and the charged particle device to: a) process at least a portion of a sub-beam processable area with each sub-beam, the sub-beam processable area comprising an array of sections having rows of sections and columns of sections, each row of sections defining an elongate region that is substantially equal to or smaller than a pitch at the sample surface of the sub-beams in the multi-beam, the processing comprising processing a plurality of the sections; b) expose at least a portion of a sub-beam scannable area with each sub-beam, the sub-beam scannable area comprising an array of sections having rows of sections and columns of sections, each row of sections defining an elongate region that is substantially equal to or smaller than a pitch at the sample surface of the sub-beams in the multi-beam, wherein the sample support and the charged particle device are configured to be controlled to expose a plurality of the sections; and/or c) to expose at least a portion of a sub-beam scannable area with each sub-beam, the sub-beam scannable area comprising an array of sections having rows of sections and columns of sections, each row of sections defining an elongate region that is substantially equal to or smaller than a pitch at the sample surface of the sub-beams in the multi-beam; and perform a sample alignment operation between scanning different sections in the array of sections.

According to an aspect of the invention, there is provided an image rendering derived from a scan of a sample, the image comprising a plurality of processed areas arranged in a grid, each processed area corresponding to a portion of a sample surface scanned by a sub-beam of a multi-beam arrangement, the grid having a dimension corresponding to the pitch of the sub-beams of the multi-beam arrangement, each processed area comprising an array of sections arranged in rows of the sections and columns of the sections, a row of processed sections in the processed area corresponding to an elongate region having an elongate dimension of the width of a processed area, desirably each processed area having the sections arranged in the same grid, desirably the sections in the elongate region are dimensioned similarly in the elongate dimension.

According to an aspect of the invention, there is provided a method of processing a sample using a multi-beam of sub-beams of charged particles using a charged particle device for projecting the multi-beam onto a sample surface, the method comprising: using the charged particle device to project a plurality of sub-beams of charged particles in a multi-beam arrangement onto a portion of a sample surface, the portion corresponding to the field of view of the multi-beam arrangement, each sub-beam assigned to a sub-portion of the portion, each sub-portion corresponding to the field of view of the corresponding sub-beam of the multi-beam arrangement, wherein the sub-portion comprises a plurality of elongate regions extending across the field of view in a first direction and together having an area that comprises the area of the sample surface of the sub-portion, each elongate region comprising a plurality of sections arranged within the elongate region, the elongate regions being optionally similarly dimensioned in a direction oblique or perpendicular to the first direction; and controlling a sample support and the charged particle device so that a sub-beam of the multi-beam arrangement scans sections within the respective sub-portion, the scanning of sections comprising: moving the sample in a direction parallel to a first direction and moving the multi-beam relative to the sample surface in a direction parallel to a second direction, preferably angled with respect to the first direction, to scan a section; and scanning a next section that adjoins the previous scanned section using the same movements.

According to an aspect of the invention, there is provided a charged particle assessment system comprising a sample support configured to support a sample; a charged particle device configured to project a plurality of sub-beams of charged particles in a multi-beam arrangement onto a portion of a sample surface, the portion corresponding to the field of view of the multi-beam arrangement, each sub-beam assigned to a sub-portion of the portion, each sub-portion corresponding to the field of view of the corresponding sub-beam of the multi-beam arrangement, wherein the sub-portion comprises a plurality of elongate regions extending across the field of view in a first direction and together having an area that comprises the area of the sample surface of the sub-portion, each elongate region comprising a plurality of sections arranged within the elongate region, the elongate regions being optionally similarly dimensioned in a direction oblique or perpendicular to the first direction; and a controller configured to control the sample support and the charged particle device so that a sub-beam of the multi-beam is controlled to scan sections within the respective sub-portion so that the sample is moved in a direction parallel to a first direction, the multi-beam is moved relative to the sample surface in a direction parallel to a second direction, preferably angled with respect to the first direction, and after each section is scanned it becomes a previously scanned section; and a next section that adjoins the previous scanned section is scanned using the same movements.

According to an aspect of the invention, there is provided a charged particle assessment system, comprising: a sample support for supporting a sample having a sample surface; and a charged particle device configured to direct a multi-beam of sub-beams of charged particles onto the sample surface, a portion of the sample surface corresponding to a multi-beam output region of the charged particle device facing the sample surface, the system being configured to control the sample support and charged particle device so that the portion is scanned by the sub-beams of the multi-beam, a sub-portion of the portion being assigned to each sub-beam, wherein: the system is configured to control the sample support to displace the sample in a direction oblique or perpendicular to a first direction in successive steps and, at each step, to move the sample in a direction parallel to the first direction so that, at each step, each sub-beam scans over a section of the corresponding sub-portion in a direction parallel to the first direction, wherein the corresponding sub-portion in a direction parallel to the first direction comprises multiple sections; and the system is configured to control the charged particle device to repeatedly scan the multi-beam over the sample surface in a direction parallel to a second direction during the movement of the sample in the direction parallel to the first direction, wherein the system is configured to scan a further section that is either: of the plurality of sections along the sub-portion in the direction parallel to the first direction; or of the following successive step

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection system.
FIG. 2 is a schematic diagram illustrating an exemplary multi-beam charged particle assessment apparatus that is part of the exemplary charged particle beam inspection system of FIG. 1.
FIG. 3 is a schematic diagram of an exemplary electron optical column comprising a condenser lens array.
FIG. 4 is a schematic diagram of an exemplary electron optical column comprising a macro collimator and macro scan deflector.
FIG. 5 is a schematic diagram of an exemplary electron optical column comprising a beam separator.

FIG. 6 is a schematic cross-sectional view of an objective lens array of a charged particle assessment system according to an embodiment.
FIG. 7 is a bottom view of a modification of the objective lens array of FIG. 7.
FIG. 8 is a schematic diagram of a data path comprising a data processing device according to an embodiment.
FIG. 9 is a flow diagram of a method according to an embodiment.
FIG. 10 depicts processing of a region on a sample corresponding to a sub-beam processed area.
FIG. 11 depicts positioning of sub-beams in a hexagonal grid.
FIG. 12 depicts sub-beam processed areas corresponding to sub-beams arranged as shown in FIG. 11.
FIG. 13 depicts an array of sections.
FIG. 14 depicts a sequence of steps for scanning the array of FIG. 13.
FIG. 15 depicts an example leap displacement movement of a sample between formation of different groups of sub-beam processed areas.
FIG. 16 depicts alternating scanning of sub-beams within an elongate region.
FIG. 17 depicts example short-stroke movement of a sample during processing of a sub-beam processed area.
FIG. 18 is a diagram illustrating a step and scan sequence.

The schematic diagrams and views show the components described below. However, the components depicted in the figures are not to scale.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution. For example, in an IC chip of a smart phone, which may be the size of a thumbnail and include over 2 billion transistors, the size of each transistor may need to be less than 1/1000th of a human hair. To achieve the increased resolution, semiconductor IC manufacturing has become a complex and time-consuming process, with hundreds of individual steps. Errors in even one of the steps may affect the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection devices (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally considered to be references to charged particles, with the charged particles not necessarily being electrons.

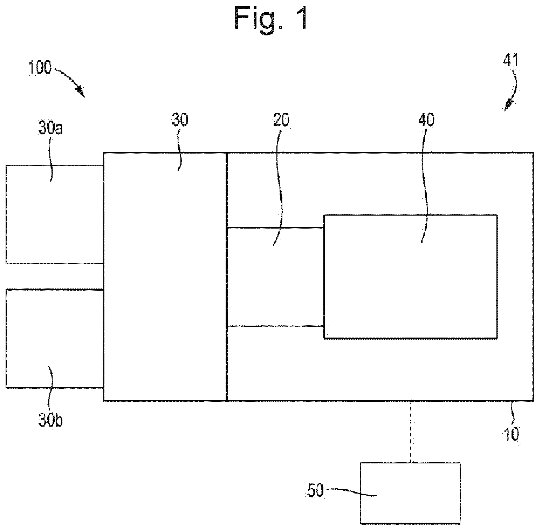

Reference is now made to **FIG. 1**, which is a schematic diagram illustrating an exemplary charged particle beam inspection system 100, which may also be referred to as a charged particle beam assessment system or simply assessment system. The charged particle beam inspection system100 of **FIG. 1** includes a main chamber 10, a load lock chamber 20, an electron beam system 40, an equipment front end module (EFEM) 30 and a controller 50. The electron beam system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron beam system 40 may comprise a multi-beam electron-optical apparatus.

The controller 50 is electronically connected to electron beam system 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam system, it should be noted that aspects of the disclosure in their broadest sense are not limited to a chamber housing an electron beam system. Rather, it is appreciated that the foregoing principles may also be applied to other devices, and other arrangements of apparatus, that operate under the second pressure.

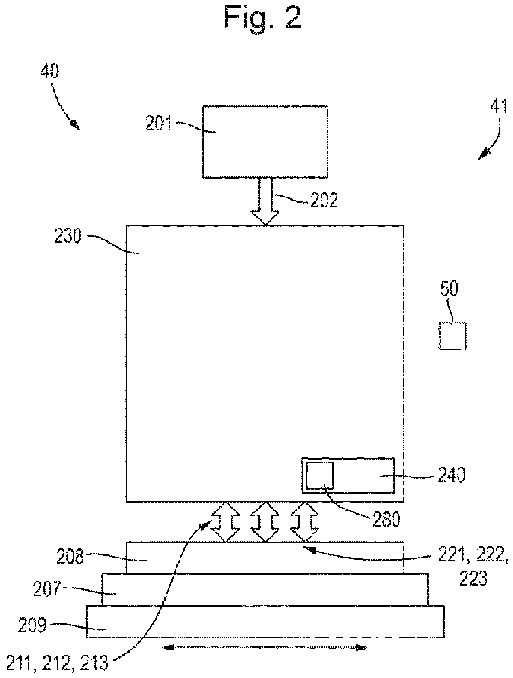

Reference is now made to **FIG. 2**, which is a schematic diagram illustrating an exemplary electron beam system 40, including a multi-beam electron-optical system 41, that is part of the exemplary charged particle beam inspection system 100 of **FIG. 1**. The electron beam system 40 comprises an electron source 201 and a projection apparatus 230. The electron beam system 40 further comprises a motorized stage 209 and a sample holder 207. The electron source 201 and projection apparatus 230 may together be referred to as the electron-optical system 41 or as an electron-optical column. The sample holder 207 is supported by motorized stage 209 so as to hold a sample 208 (e.g., a substrate or a mask) for inspection. The multi-beam electron-optical system 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds, many thousands, many tens of thousands or many hundreds of thousands of sub-beams. The sub-beams may be referred to as beamlets.

The controller 50 may be connected to various parts of the charged particle beam inspection apparatus 100 of **FIG. 1**, such as the electron source 201, the detector 240, the projection apparatus 230, and the motorized stage 209. The controller 50 may perform various image and signal processing functions. The controller 50 may also generate various control signals to govern operations of the charged particle beam inspection apparatus, including the charged particle multi-beam apparatus.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons which may be referred to as signal particles. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the electron beam system 40 such as the detector 240 (as shown in **FIG. 2**). However, the signal processing system 280 may be incorporated into any number of components of the inspection apparatus 100 or electron beam system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample. The above functions of the signal processing system 280 may be carried out in the controller 50 or shared between the signal processing systems 280 and controller 50 as convenient.

The controller 50 may control the motorized stage 209 to move sample 208 during inspection of the sample 208. The controller 50 may enable the motorized stage 209 to move the sample 208 in one or more selected directions, continuously or discontinuously. In some arrangements, the movement may be performed at a constant speed. The movement of the sample 208 may be referred to as scanning. This scanning may therefore be continuous or discontinuous. The controller 50 may control movement of the motorized stage 209 so that it changes the speed of the movement of the sample 208 dependent on various parameters. For example, the controller 50 may control the stage speed (and/or direction) depending on the characteristics of the inspection steps of scanning process and/or scans of the scanning process for example as disclosed in EPA 21171877.0 filed 3 May 2021 which is hereby incorporated in so far as the combined stepping and scanning strategy at least of the stage.

Known multi-beam systems, such as the electron beam system 40 and charged particle beam inspection apparatus 100 described above, are disclosed in US2020118784, US20200203116, US 2019/0259570 and US2019/0259564 which are hereby incorporated by reference.

The electron beam system 40 may comprise a projection assembly to regulate accumulated charges on the sample by illuminating the sample 208.

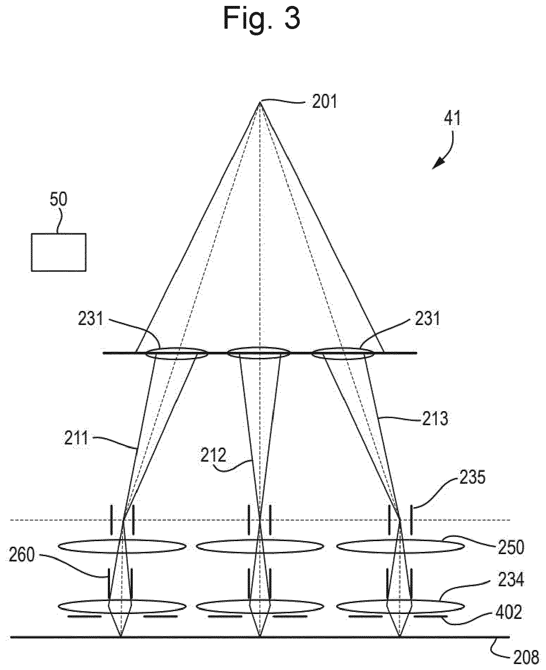

FIG. 3 is a schematic diagram of an exemplary electron-optical column 41 for use in an assessment system. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle arrangements such as those discussed herein, it will be understood however that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along sub-beam paths of sub-beams of a multi-beam.

The electron source 201 directs electrons toward an array of condenser lenses 231 (otherwise referred to as a condenser lens array). The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, preferably three, acting as electrodes, with an aperture in each plate aligned with each other and corresponding to the location of a sub-beam. At least two of the plates are maintained during operation at different potentials to achieve the desired lensing effect. Between the plates of the condenser lens array are electrically insulating plates for example made of an insulating material such as ceramic or glass, with one or more apertures for the sub-beams. An alternative arrangement one more of the plates may feature apertures each with their own electrode, each with an array of electrodes around their perimeter or arranged in groups of apertures having a common electrode.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective sub-beam 211, 212, 213 which is focused at a respective intermediate focus 233. A collimator or an array of collimators may be positioned to operate on the respective intermediate focus 233. The collimators may take the form of deflectors 235 provided at the intermediate focuses 233. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample ).

Below (i.e. downbeam of or further from source 201) deflectors 235 there is a control lens array 250 comprising a control lens 251 for each sub-beam 211, 212, 213. Control lens array 250 may comprise two or more, preferably at least three, plate electrode arrays connected to respective potential sources, preferably with insulating plates in contact with the electrodes for example between the electrodes. Each of the plate electrode arrays may be referred to as a control electrode. A function of control lens array 250 is to optimize the beam opening angle with respect to the demagnification of the beam and/or to control the beam energy delivered to the objective lenses 234, each of which directs a respective sub-beam 211, 212, 213 onto the sample 208.

Optionally an array of scan deflectors 260 is provided between the control lens array 250 and the array of objective lenses 234 (objective lens array). The array of scan deflectors 260 comprises a scan deflector 261 for each sub-beam 211, 212, 213. Each scan deflector is configured to deflect a respective sub-beam 211, 212, 213 in one or two directions so as to scan the sub beam across the sample 208 in one or two directions.

A detector module 240 of a detector is provided within or between the objective lenses 234 and the sample 208 to detect signal electrons/ particles emitted from the sample 208. An exemplary construction of such a detector module 240 is described below. Note that the detector additionally or alternative may have detector elements up-beam along the primary beam path of the objective lens array or even the control lens array.

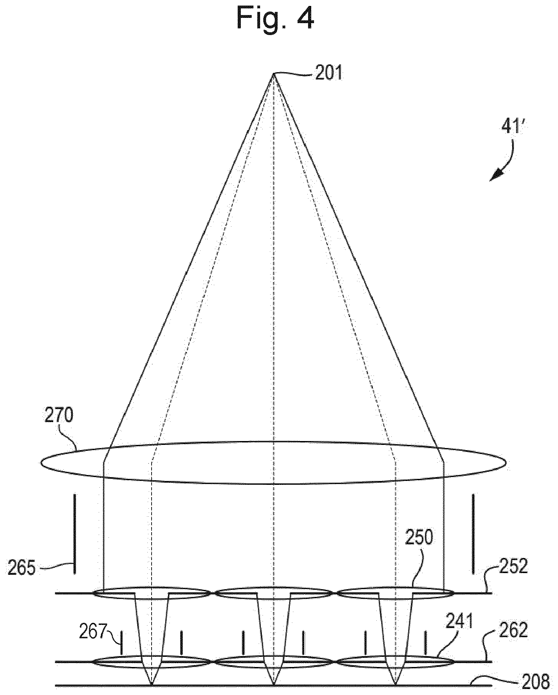

FIG. 4 is a schematic diagram of an exemplary electron beam system having an alternative electron-optical column 41'. The electron-optical column 41' comprises an objective lens array 241. The objective lens array 241 comprises a plurality of objective lenses. The objective lens array 241 may be an exchangeable module. For conciseness, features of the electron beam system that have already been described above may not be repeated here.

As shown in FIG. 4, the electron-optical column 41' comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The beam may separate into the sub-beams on meeting the control lens array 250. The sub-beams are substantially parallel on entry to the control lens array 250. The sub-beams of the multi-beam may be arranged in a pattern which may be referred to as a multi-beam arrangement. The pattern may form a grid. The grid may be hexagonal, rectilinear, rhombic or square. In the example shown, a collimator is provided up-beam of the objective lens array assembly.

The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 comprise a magnetic lens and/or an electrostatic lens. In another arrangement (not shown), the macro-collimator may be partially or wholly replaced by a collimator element array provided down-beam of the upper beam limiter.

In the electron-optical column 41' of FIG. 4 a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250. In another arrangement (not shown), the macro scan deflector 265 may be partially or wholly replaced by a scan deflector array, for example as a scan deflector 267 for each sub-beam. In other embodiments both a macro scan deflector 265 and the scan-deflector array are provided, and they may operate in synchronization.

In some embodiments, the electron-optical system 41 further comprises an upper beam limiter 252. The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

In some embodiments, as exemplified in FIG. 4, the objective lens array assembly (which is a unit that comprises the objective lens array 241) further comprises a beam shaping limiter 262. The beam shaping limiter 262 defines an array of beam-limiting apertures. The beam shaping limiter 262 may be referred to as a lower beam limiter, lower beam-limiting aperture array or final beam-limiting aperture array. The beam shaping limiter 262 may comprise a plate (which may be a plate-like body) having a plurality of apertures. The beam shaping limiter 262 may be down-beam from at least one electrode (optionally from all electrodes) of the control lens array 250. In some embodiments, the beam shaping limiter 262 is down-beam from at least one electrode (optionally from all electrodes) of the objective lens array 241. In an arrangement, the beam shaping limiter 262 is structurally integrated with an electrode of the objective lens array 241. Desirably, the beam shaping limiter 262 is positioned in a region of low electrostatic field strength.

The alignment of the beam liming apertures with the objective lens array is such that a portion of a sub-beam from the corresponding objective lens can pass through the beam-limiting aperture and impinge onto the sample 208, so that only a selected portion of the sub-beam incident onto the beam shaping limiter 262 to pass through the beam-limiting aperture.

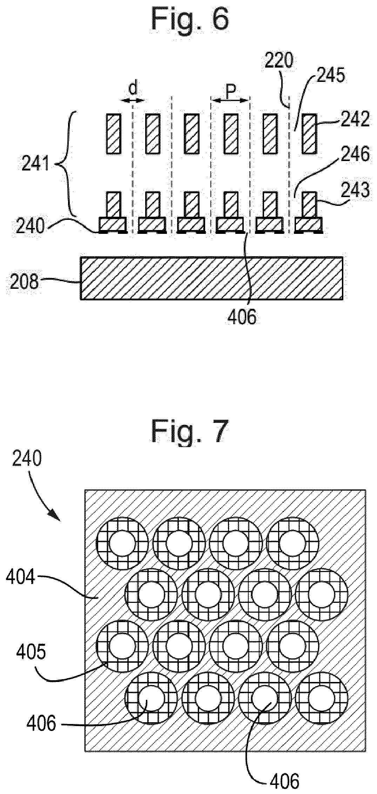

Any of the objective lens array assemblies described herein may further comprise a detector 240. The detector detects electrons emitted from the sample 208. The detected electrons may include any of the electrons detected by an SEM, including signal particles such as secondary and/or backscattered electrons emitted from the sample 208. An exemplary construction of a detector 240 is described in more detail below with reference to **FIGs. 6** and **7.**

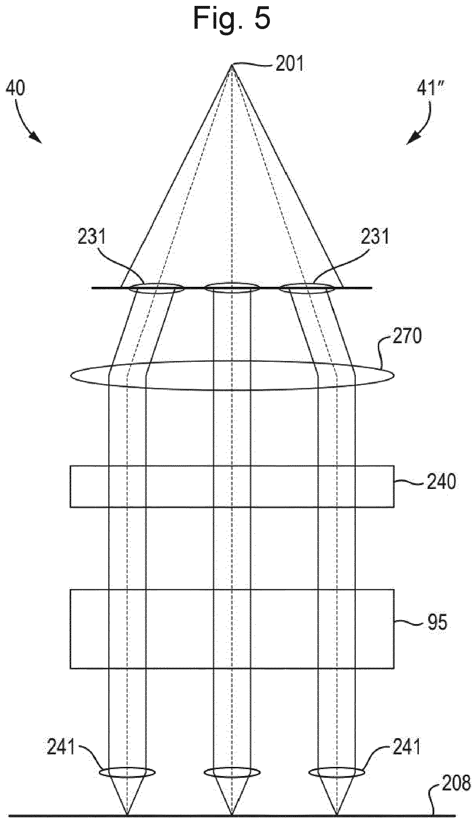

**FIG. 5** schematically depicts an electron beam system 40 including an electron-optical column 41" according to an embodiment. Features that are the same as those described above are given the same reference numerals. For conciseness, such features are not described in detail with reference to **FIG. 5**. For example, the source 201, the condenser lenses 231, the macro collimator 270, the objective lens array 241 and the sample 208 may be as described above.

As described above, in an embodiment the detector 240 is between the objective lens array 241 and the sample 208. The detector 240 may face the sample 208. Alternatively, as shown in **FIG. 5**, in an embodiment the objective lens array 241, which comprises the plurality of objective lenses, is between the detector 240 and the sample 208.

In an embodiment a deflector array 95 is between the detector 240 and the objective lens array 241. In an embodiment the deflector array 95 comprises a Wien filter array so that deflector array may be referred to as a beam separator. The deflector array 95 is configured to provide a magnetic field to disentangle the charged particles projected to the sample 208 apart from the secondary electrons from the sample 208 towards the detector 240. The deflector array 95 may function as a scanning deflector. Such a scanning deflector may scan the sub-beams relative to the sample surface during assessment of the sample 208.

In an embodiment the detector 240 is configured to detect signal particles by reference to the energy of the charged particle, i.e. dependent on a band gap. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be a scintillator array for example of fluorescing strip between the beams and that are positioned up beam along the primary beam path with respect to the Wien filter. Primary beams passing through the Wien filter array (of magnetic and electrostatic strips orthogonal to the primary beam path) have paths up beam and down beam of the Wien filter array that are substantially parallel, whereas signal electrons from the sample are directed by the Wien filter array towards the scintillator array. The generated photons are directed via a photon transport unit (e.g. an array of optical fibers) to a remote optical detector which generates a detection signal on detection of a photon

The objective lens array 241 of any embodiment may comprise at least two electrodes in which are defined aperture arrays. In other words, the objective lens array comprises at least two electrodes with a plurality of holes or apertures. **FIG. 6** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The objective lens array 241 may comprise two electrodes, as shown in **FIG. 6**, or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. A benefit of two electrode lens over an Einzel lens is that the energy of an incoming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than an objective lens of the objective lens array.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the charged particle beam by a factor greater than 10, desirably in the range of 50 to 100 or more.

A detector 240 is provided to detect signal particles, i.e. secondary and/or backscattered charged particles, emitted from the sample 208. The detector 240 is positioned between the objective lenses 234 and the sample 208. On direction of a signal particle the detector generates a detection signal. The detector 240 may otherwise be referred to as a detector array or a sensor array, and the terms "detector" and "sensor" are used interchangeably throughout the application.

An electron-optical device for the electron-optical system 41 may be provided. The electron-optical device is configured to project a beam of electrons towards the sample 208. The electron-optical device may comprise the objective lens array 241. The electron-optical device may comprise the detector 240. The array of objective lenses (i.e. the objective lens array 241) may correspond with the array of detectors (i.e. the detector 240) and/or any of the beams (i.e. the sub-beams).

An exemplary detector 240 is described below. However, any reference to the detector 240 could be a single detector (i.e. at least one detector) or multiple detectors as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIG. 7.**

The detector 240 may be positioned between the objective lens array 241 and the sample 208. The detector 240 is configured to be proximate the sample 208. The detector 240 may be very close to the sample 208. Alternatively, there may be a larger gap from the detector 240 to the sample 208. The detector 240 may be positioned in the device so as to face the sample 208. Alternatively, the detector 240 may be positioned elsewhere in the electron-optical system 41 such that part of the electron-optical device that is not a detector faces the sample 208.

**FIG. 7** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 7**, the beam apertures 406 are in a hexagonal close packed array. The beam apertures 406 can also be differently arranged, e.g. in a rectangular, or a rhombic, array. The beam arrangement of the hexagonal arrangement in **FIG. 7** may be more densely packed than a square beam arrangement. The detector elements 405 may be arranged in a rectangular array or a hexagonal array. The beam apertures may correspond to the multi-beam arrangement of the sub-beams towards the substrate 404.

Capture electrodes 405 form the bottommost, i.e. most close to the sample, surface of the detector module 240. Between the capture electrodes 405 and the main body of the silicon substrate 404 a logic layer is provided. Logic layer may include amplifiers, e.g. Trans Impedance Amplifiers, analogue to digital converters, and readout logic. In an embodiment, there is one amplifier and one analogue to digital converter per capture electrode 405. A circuit featuring these elements may be comprised in a unit area referred to as a cell that is associated with an aperture. The detector model 240 may have several cells each associated with an aperture. Within or on the substrate is a wiring layer connected to the logic layer and externally connecting the logic layer of each cell for example via power, control and data lines. The integrated detector module 240 described above is particularly advantageous when used with a system having tunable landing energy as secondary electron capture can be optimized for a range of landing energies. A detector module in the form of an array can also be integrated into other electrode arrays, not only the lowest electrode array. Such a detector module may feature detectors that are scintillators or semiconductor detectors such as PIN detectors, for example above the down-beam most surface of the objective lens. Such detector modules may feature a similar circuit architecture as a detector module comprising a current detector. Further details and alternative arrangements of a detector module integrated into an objective lens can be found in EP Application Numbers 20184160.8 and 20217152.6, which document is hereby incorporated by reference at least so far as details of the detector module.

The detector may be provided with multiple portions and more specifically, multiple detecting portions. The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406, which provides an examples of such a detector. As mentioned the detection signal from the detector module is used to generate an image. With multiple detecting portions, the detection signal comprises components from the different detecting signals that may be processed as data sets or in a detection image.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the system and can be swapped between operable and non-operable positions without opening the electron beam system.

In some embodiments, one or more aberration correctors are provided that reduce one or more aberrations in the sub-beams. Aberration correctors positioned in, or directly adjacent to, the intermediate foci (or intermediate image plane) may comprise deflectors to correct for the source 201 appearing to be at different positions for different beams. Correctors can be used to correct macroscopic aberrations resulting from the source that prevent a good alignment between each sub-beam and a corresponding objective lens. Aberration correctors may correct aberrations that prevent a proper column alignment. Aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. Aberration correctors may reduce one or more of the following: field curvature; focus error; and astigmatism.

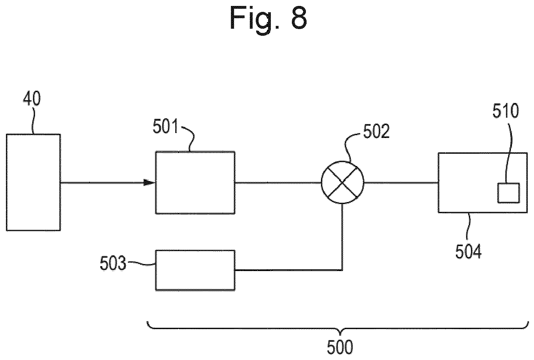

Images (which may be represented by image data sets) output from a charged particle assessment system, e.g. electron beam system 40, may be processed automatically to detect defects in samples 208 being assessed. An image data set (which may be referred to as an image) may comprise data points. The data points may be referred to as pixels. A region of pixels is an image which may be referred to as a clip. The region of pixels may surround a pixel or group of pixels identified as a potential defect. An example data processing device 500 for detecting defects in images generated by a charged particle assessment system is depicted in **FIG. 8.** Data processing device 500 may be part of controller 50, part of another computer in the fab or integrated elsewhere in the charged particle assessment device. It should be noted that the arrangement of components of the data processing device 500 as shown and described with reference to **FIG. 8** is exemplary and is provided to aid explanation of the functions of data processors that operate on the images generated by the charged particle assessment system. Any feasible arrangement conceivable by a person skilled in the art of data processors that is able to achieve the functions of the data processing device 500 as described herein may be used.

In some embodiments, the data processing device 500 comprises a filter module 501 which receives and filters a sample image from a charged particle assessment system 40, a reference image generator 503 which generates a reference image based on source images, a comparator 502 which compares the filtered sample image to the reference image and an output module 504 which processes and outputs the result of the comparison.

Filter module 501 applies a filter, e.g. a uniform filter, of predetermined size to the sample image. Applying a uniform filter comprises convoluting the sample image with a uniform kernel. The size of the uniform kernel is determined, e.g. by the user, for inspection of a given sample based on, for example, the size of features on the sample, the size of defects to be detected, the resolution of the charged particle assessment system, the amount of noise in the images and the desired compromise between sensitivity and selectivity. Deviation from a mathematically uniform filter is permissible. For example corner filters could have values that would slightly overweight those pixels but not significantly. Non-uniform filters, e.g. a Gaussian filter, may be conveniently implemented by convolution with a suitable kernel. Filter module 501, especially when configured to apply a uniform filter of predetermined size, is conveniently implemented by dedicated hardware, e.g. an FPGA or an ASIC.

The reference image generator 503 may be operable in one or more modes, each mode representing a different approach to generation of the reference image.

In a library mode, the reference image generator 503 averages a large number of source images obtained from previous scans of patterns nominally the same as the pattern currently being assessed. Such images may have been generated earlier in the same batch of samples, or from samples in previous batches. The library images may be derived from test samples or production samples. Before averaging, the images are desirably aligned with one another. Averaging the source images to generate the reference image has the effect of reducing noise. Averaging the source images in this way also averages away any defects that might be visible in the source images.

In the case where the pattern being inspected is a repeating pattern, it is possible to generate the reference image by averaging a plurality of shifted versions of a source image. If either or both dimensions of the unit cell are not equal to an integer number of pixels, the shift amount can be rounded to the nearest pixel or a fractional pixel shift can be effected by interpolation, for example linear or cubic interpolation, such as bicubic interpolation, or any other known interpolation technique. Another possibility is to shift by a multiple of the pitch of the repeating pattern such that the multiple is an integer number of pixels. In effect, multiple instances of the unit cell are extracted from the source image and averaged. This approach may be referred to as an example of an array mode, more specifically of providing a reference image for an array mode.

In a die-to-die mode, three columns of a multi-column charged particle assessment device may be used to generate a sample image and two reference images. An image aligner is provided to align the images before they are supplied to the reference image generator 503 and filter module 501 as appropriate. This arrangement is particularly efficient where the spacing between columns is equal to the die size of the sample being inspected since the columns will then automatically scan corresponding pattern features simultaneously. In a case where there is a difference between the column spacing and die size, a buffer may be employed to correct the timing of images input to the data processing device.

In an alternative variant of die-to-die mode, the same beam (of the same column in the case of a multi-column system) is used to generate a sample image and two reference images. This has the advantage that column to column and beam to beam corrections (e.g., correction of the relative position of a beam relative to the ideal beam position for that beam or even for each beam) are not required and the routing of data can be simplified. Using the same beam avoids the calibration, e.g. assessment of the offset, between beams for the different scans that are compared. Using the same beam means that although the beam may have an offset with respect to the ideal beam position, there is no positional offset to correct for when comparing data retrieved from the scans. However, the need for data buffering might be increased, for example in frequency, if not in quantity of data buffered before the start of the comparison of the data from different dies.

An alternative version of array mode using a single column, e.g. of a single-column system, provides a sample image which is compared against a reference image derived from two shifted versions of itself as source images. A buffer may be used to provide the shifted images.

It should be noted that it is also possible to apply the uniform filter to the source images and/or the reference images, in particular where the reference image is derived from a small number of source images that are obtained concurrently with the source image.

With reference again to **FIG. 8**, comparator 502 may be any logic circuit capable of comparing two values, for example an XOR gate or a subtractor. Comparator 502 is also suitable for implementation by dedicated hardware, e.g. an FPGA or an ASIC. Desirably, comparator 502 is implemented on the same dedicated hardware as filter module 501.

In some cases, the reference image generator 503 can also be implemented in dedicated hardware, especially where the reference image generator operates only in a mode where the reference image is generated from a small number of, e.g. two, source images. In that case it is desirable that the reference image generator is implemented in the same dedicated hardware as the comparator and/or filter module. The mathematical operations to average pixels of source images and compare to a pixel of a sample image can, in suitable cases, be combined into a single logic circuit.

Output module 504 receives the results output by comparator 502 and prepares output to the user or other fab systems. The output may be in any of several different forms. In a simplest option, the output may simply be an indication that the sample has or does not have a defect. However, since almost all samples will have at least one potential defect more detailed information is desirable. The output may comprise, for example, a map of defect locations, a difference image, and/or information as to the severity of a possible defect represented by the magnitude of the difference between the sample image and the reference image. Output module 504 may also filter the potential defects, e.g. by only outputting defect locations where the magnitude of the difference between the sample image and the reference is greater than a threshold or the density of pixels showing a difference is higher than a threshold. Another possibility is to output only a predetermined number of most serious defect sites, indicated by the magnitude of the difference. This may be effected by storing defect sites in a buffer 510 and, when the buffer is full, overwriting the lowest magnitude defect if a higher magnitude defect is detected.

Any suitable format for the output of defect information as a data set may be used, e.g. a list or a map. Desirably, output module 504 may output clips. A clip is an image of a portion of the sample surface, or a region of pixels representative of potential defects. This allows the potential defect to be further examined to determine if clip is representative of a defect. That is that the defect is not actually a nuisance signal. Processing of the clip may determine if the defect is sufficiently significant to affect operation of the device structure which either is or could be formed on or present in the sample. The rest of the source image, i.e. those parts not saved as clips, may be discarded so as to avoid to conserve data storage and data transfer requirements.

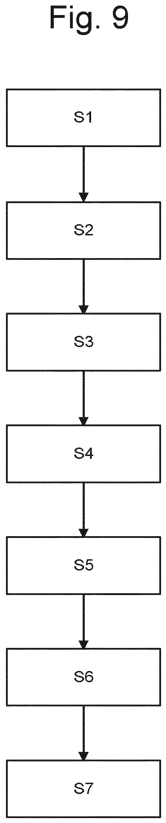

**FIG. 9** depicts a framework (or process flow) for a method of processing a sample 208 using a multi-beam of sub-beams of charged particles. The method may be performed using a charged particle assessment system. In this context 'processing of the sample' is intended to mean relative scanning of the charged particle beam and the surface of the sample 208, usually scanning of the charged particle beam over the surface of the sample. The scanning may be for example by electron-optical actuation of the charged particle beam for example by a deflector and/or relative motion of the sample to the path of the charged particle beam for example by the actuatable stage. In an assessment system, the processing may comprise detecting signal electrons from the sample. The signal electrons are generated in response to the relative scanning of the sample and the charged particle beam.

The charged particle assessment system may comprise a sample support. The sample support supports the sample 208. The sample 208 has a sample surface. The sample support may comprise, or consist of, a stage 209. The stage 209 may take any of the forms described above with reference to **FIG. 1-7**. The stage 209 may for example support the sample 208 via a sample holder 207. The sample support may be configured to provide relative movement between the sample 208 and the column. The sample support may comprise a motorized stage 209 for example.

The charged particle assessment system may comprise a charged particle device. The charged particle device may comprise, or consist of, an electron optical column, or even a plurality of columns, e.g. a multi-column. The charged particle device projects the multi-beam onto the sample surface. The multi-beam may be referred to as a multi-beam arrangement. The charged particle device may take any suitable form of the electron optical column such as described above with reference to **FIG. 1-7.** In an arrangement with a plurality of columns, the columns may comprise the electron-optical system 41 described in any of the above embodiments or aspects. As a plurality of columns (or a multi-column system), the devices may be arranged in an array which may number two to one hundred columns or more.

The method comprises performing steps S1-S5 of **FIG. 9** in sequence. The method may also comprise performing steps S6 and S7 of **FIG. 9** in sequence. In some embodiments, the charged particle assessment system comprises a controller 50 that causes the system to perform the steps. The controller 50 may take any of the forms described above with reference to **FIG. 1** and **2** or other forms. The controller 50 may be configured to control at least the sample support and the charged particle device (e.g., column) to perform the method. The controller 50 may take the form of distributed sub-controllers. For example, the controller 50 may comprise any suitable combination of data-processing hardware, firmware, software and/or computer-controlled actuators, sensors, etc. necessary for providing the desired functionality.

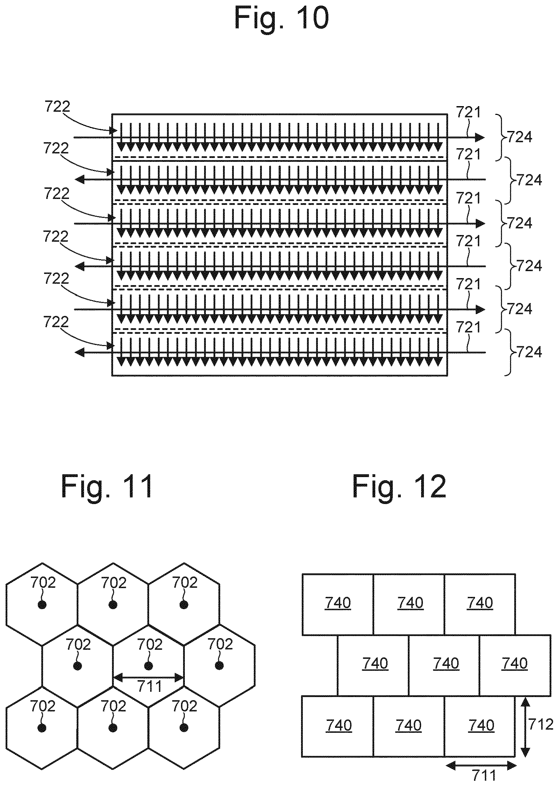

In step S1, as exemplified in **FIG. 10** for a single example sub-beam of the multi-beam, the sample support is used to move the sample 208 in a direction parallel to a first direction (e.g., along one of the horizonal paths 721 shown in **FIG. 10**). The movement of the sample 208 may be considered as being relative to a path of the multi-beam (e.g., an overall path of the multi-beam, neglecting variations in the paths of the sub-beams due to electrostatic deflection). During this movement the charged particle device is used to repeatedly move the multi-beam relative to the sample surface in a direction parallel to a second direction, different from the first direction (e.g., along the vertical paths 722 shown in **FIG. 10**). Thus scanning, for example processing, of the sample surface results in the scanning of an elongate region 724. Scanning of the elongate region 724 of the surface of the sample 208 by a sub-beam is continuous. The charged particle device may, for example, comprise an electrostatic deflector configured to perform the movement of the multi-beam relative to the sample surface in step S1. The deflector may take any of the forms described above with reference to **FIG. 3-7.** The deflector may be implemented as an array of scan deflectors 260, 267 as exemplified in **FIG. 3**, as a macro scan deflector 265 as exemplified in **FIG. 4**, or as a deflector array 95 as exemplified in **FIG. 5.** The component of movement of the multi-beam relative to the sample surface that is provided by the charged particle device may be referred to as electrostatic scanning of the multi-beam and/or of the sub-beams. In some embodiments, the deflectors (e.g., deflectors 260, 265, 267 and 95) are positioned relatively close to the sample 208. As a consequence, the leverage (or length of beam path) over which the deflectors operate is small relative to the scale of the sample 208. Other designs of scan deflectors are known where the scan deflectors are at a greater distance from the sample and therefore have greater leverage. A smaller leverage reduces a scan distance on the sample 208 over which the sub-beams can be scanned without introducing aberrations that exceed an acceptable threshold. For a scan distance of 0.5 or 2.0 microns, the unacceptable threshold may be about ten percent or greater.

The combination of the movement of the sample 208 by the sample support and the electrostatic scanning (movement of the multi-beam relative to the sample surface by the charged particle device) respectively scans each sub-beam in the direction parallel to the first direction and repeatedly in the direction parallel to the second direction to process an elongate region 724 on the sample surface. Each sub-beam may process a different respective elongate region 724 at the same time. The different respective elongate regions 724 are of different respective portions of the sample assigned to different sub-beams of the multi-beam arrangement, which may be referred to as processed areas 740. The multi-beam can thus simultaneously process a plurality of elongate regions 724 corresponding to the plurality of sub-beams in the multi-beam. The processing may comprise causing charged particles to be emitted from the sample 208. The emitted charged particles may be detected and used to determine information about the sample surface in the respective elongate regions 724. The emitted charged particles may, for example, be used to obtain images of the processed elongate regions 724. The images may be represented by image data sets. Nominally identical patterns in different images may be compared with each other to detect defects.

The paths 721 and 722 and the elongate regions 724 are depicted schematically in **FIG. 10** so as to be visible in the diagram. In practice the paths 721 and 722 will be more closely spaced and many more elongate regions 724 will be processed, for example twenty to one thousand. The widths of the elongate regions 724, which may be defined by an available range of electrostatic deflection, may typically be in the range of 0.2-5.0 microns, for example 0.5-2.0 microns. The lengths of the regions 724, which may be defined by the pitch of the sub-beams in the multi-beam, may typically be in the range of 50-500 microns. Together the different elongate regions 724 of the surface of the sample scanned by a sub-beam define the processed region 740. Scanning and thus processing of the processed area 740 by a sub-beam is thus discontinuous.

In the example of **FIG. 10**, the first and second directions are horizontal and vertical (in the plane of the page). The first and second directions are thus perpendicular to each other in this example. Thus, the movement of the sample surface relative to the multi-beam, which may be a continuous movement (e.g., along path 721), may be in a direction orthogonal to the relative movement between the multi-beam and the sample provided by the charged particle device (e.g., the direction of electrostatic scanning of the sub-beams). In other embodiments, the first and second directions are oblique relative to each other.

Note the movement is continuous along the length of the path 721. The length of the path 721 corresponds (i.e. is the same as) the length of the elongate region 724. The length of the path 721 is the pitch between sub-beams in the direction of the elongation of the elongate region 724. Beyond or further than the length of the path, greater than the sub-beam pitch in the direction of the path 721 or the elongate region 724, the movement is discontinuous. This is because the region of the sample scanned at one end of the elongate region 274 (if the sub-beam defines a side of the multi-beam arrangement) or the regions at both ends (if the sub-beam is between two other sub-beams in the multi-beam arrangement) are scanned by each adjoining sub-beam respectively.

With time, properties of sub-beams and the electron-optical components which operate on the sub-beams vary. This variation may be referred to as drift. Thus variation in the properties of the sub-beams and the strengths of electron-optical components such as deflectors of an array of deflectors may occur. The drift in the electron-optical properties of the sub-beam and the strength of the deflectors of the deflector array (which may be referred to as sub-beam deflectors because each deflector may operate on a different sub-beam) may lead to variations in the position on the surface of the sample on which the respective sub-beam is incident. Charged particles such as electrons impart heat to a surface on impact. Sub-beams therefore apply a heat load to the surface of the sample. A sub-beam can heat the sample 208. Such an applied heat load may cause distortion such as thermal expansion of the surface of the sample. The application of heat therefore adds to the uncertainty of the location of the incidence of a sub-beam on a sample surface. The heat load applied to the sample surface may contribute to the drift of the relative position of the sample and a sub-beam with time. In view of the localized heating of the sample surface by multi-beam arrangement (or the footprint of the sample surface on which the multi-beam is incident) and the localization of each sub-beam to an elongate region at a moment in time, the heat load applied is non-uniform. Expansion of the sample surface is uncommon to all sub-beams of the multi-beam. The impact of the drift from one or more of its different sources to position accuracy of each sub-beam with respect to its respective elongate region is too great for each sub-beam to reliably scan the elongate region of the sample surface.

In embodiments of the present disclosure, various strategies are proposed which alleviate the impact of the drift on the positional accuracy of the sub-beams with respect to the sample surface to enable improved scanning and processing of a processed area by the respective sub-beam of the multi-beam arrangement.

In an embodiment, the combination of the movement of the sample 208 by the sample support and the electrostatic scanning (movement of the multi-beam relative to the sample surface by the charged particle device) respectively scans each sub-beam in the direction parallel to the first direction and repeatedly in the direction parallel to the second direction to process only a section 730 of an elongate region 724 on the sample surface rather than the full elongate region 724.

For example, a charged particle assessment system may be provided that has a sample support and a charged particle device. The charged particle device directs a multi-beam of sub-beams of charged particles onto the sample surface. A portion of the sample surface corresponds to a multi-beam output region of the charged particle device facing the sample surface. The system controls the sample support and charged particle device so that the portion is scanned by the sub-beams of the multi-beam. A sub-portion of the portion is assigned to each sub-beam. The sample support displaces the sample 208 in a direction oblique or perpendicular to the first direction in successive steps. At each step, the sample 208 is moved in a direction parallel to the first direction so that, at each step, each sub-beam scans over a section 730 of the corresponding sub-portion in a direction parallel to the first direction (e.g., a section 730 of an elongate region 724). The corresponding sub-portion comprises multiple sections 730 in a direction parallel to the first direction. The multiple sections 730 form an elongate region 724. The charged particle device repeatedly scans the multi-beam over the sample surface in a direction parallel to the second direction during the movement of the sample 208 in the direction parallel to the first direction. A further section 730 is then scanned. The further section 730 may be of the plurality of sections 730 along the sub-portion in the direction parallel to the first direction (e.g., in the same row of sections 730), or of the following successive step (e.g., in a different row of the sections 730).

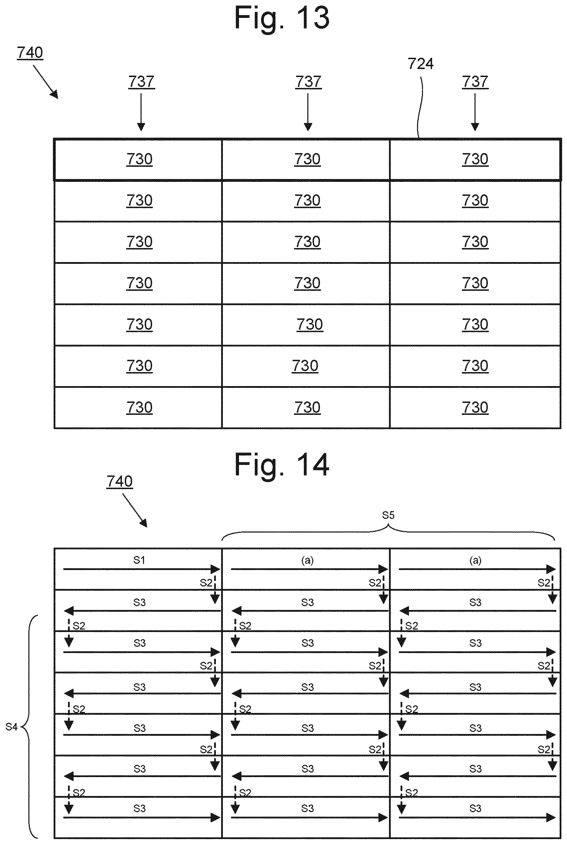

Scanning such a reduced area (i.e. the section 730 rather than the full elongate region 724) enables an impact of drift to be reduced, for example as will be explained below. A layout of the sections 730 are discussed in further detail below with reference to **FIG. 13.** Each sub-beam can process a section 730 of a different respective elongate region 724. The multi-beam can thus simultaneously process a plurality of sections 730 of elongate regions 724 corresponding to the plurality of sub-beams in the multi-beam. The processing may comprise causing charged particles to be emitted from the sample 208. The emitted charged particles may be detected and used to determine information about the sample surface in the respective sections 730. The emitted charged particles may, for example, be used to obtain images of the sections 730. The images may be represented by image data sets. Nominally identical patterns in different images may be compared with each other to detect defects.

Adjoining sections 730 of the elongate regions 724 in the direction perpendicular to the elongate direction may be as depicted in **FIG 10**, considering the elongate regions 724 in **FIG. 10** as the sections 730 in the adjoining arrangement. The same comments apply, for example: that the paths 721 and 722 and the elongate regions 724 (which in the present context correspond to the sections 730) are depicted schematically in **FIG. 10** so as to be visible in the diagram; that the paths 721 and 722 are more closely spaced so that many more sections 730 are processed, for example twenty to one thousand; that the widths of the sections 730, which may be defined by an available range of electrostatic deflection, may typically be in the range of 0.2-5.0 microns, for example in the range of 0.5-2.0 microns; and that the lengths of the sections 730, which may be defined relative to the pitch of the sub-beams in the multi-beam, may typically be a proportion of the range of 50-500 microns. Together the different sections 730 of the surface of the sample scanned by a sub-beam define: the elongate region 724 in the direction of the path 721, a column 737 in the direction of relative motion between sections 730 in the column 737 (see **FIG. 13** also); and scanning and thus processing of all sections 730 of all the elongate regions 724 define the processed area 740. Scanning of the sections 730 within a column and within an elongate region 274 by a sub-beam is thus discontinuous.

Where the method processes sections 730 arranged in an array of rows of sections 730 and columns of sections 730, as depicted in **FIG. 13** and **14** discussed below, each section 730 may be processed by moving the sample in a direction parallel to the rows while using the charged particle device to repeatedly move the multi-beam relative to the sample surface in a direction oblique or perpendicular to the row. Desirably, the direction oblique or perpendicular to the row is a direction parallel to the columns of the array of sections 730.

Each sub-beam scans a section 730 of a respective elongate region 724. Each elongate region 724 may have a length substantially equal to a pitch at the sample surface of the sub-beams in the multi-beam in the first direction. Each elongate region 724 may contain at least two of the sections 730. In an arrangement, the two sections 730 are of similar size; alternatively the sections 730 are of different size. For example, one section 730 may be a factor larger than another of the sections 730. A section 730 may be larger than half the pitch at the sample surface of a sub-beam.

When for example the sections 730 are of similar length, the distance of movement of the sample 208 in step S1 may thus be substantially equal to or less than one half of the pitch at the sample surface of the sub-beams in the multi-beam in the first direction. The limited movement in step S1 ensures that, even after step S1 has been performed multiple times in accordance with steps S1-S5 or S1-S7, each sub-beam predominantly or exclusively processes the sample surface in its own assigned region on the sample surface. As described below, each assigned region may be referred to as a sub-beam processed area 740, a sub-beam processable area, or a sub-portion (assigned to the sub-beam) of a portion of the sample surface corresponding to a field of view of the multi-beam (multi-beam arrangement). The assigned region for a sub-beam may also be referred to as the field of view of the sub-beam. The sub-beam processed area 740 may comprise a plurality of the elongate regions 724, each elongate region 724 extending across the sub-beam processed area 740 in the first direction. The plurality of elongate regions 724 may together have an area that comprises or consists of the area of the sample surface of the sub-beam processed area 740. The elongate regions 724 may be similarly dimensioned in a direction oblique or perpendicular to the first direction.

The combination of the sub-beam processed areas 740 may be referred to as a footprint of the charged particle device for example on the sample surface, a field of view of the charged particle device, or a field of view of the multi-beam or multi-beam arrangement. The scanning of the sub-beams over the footprint on the sample surface defines the limits of the continuous scanning by all the sub-beams of the multi-beam arrangement; each sub-beam scanning the respective sub-beam processed area of the sample surface within the footprint. Scanning more of the sample surface requires discontinuous scanning. The sample is moved relative to the path of the multibeam arrangement so that the sub-beams can scan respective sub-beam processed areas within a new footprint of the sample surface. The new footprint of the sample surface may adjoin the previous footprint of the sample surface, so that the continuous surface can be scanned and thus processed by discontinuous scanning.

A section 730 or elongate region 724 processed by one sub-beam will not overlap significantly or at all with any section 730 or elongate region 724 processed by a neighboring sub-beam. In some embodiments, the distance of movement of the sample in step S1 is substantially equal to the pitch at the sample surface of the sub-beams in the multi-beam in the first direction divided by a whole number, optionally divided by 3, optionally divided by 4, optionally divided by 5, optionally divided by 6, optionally divided by 8, optionally divided by 10 or more. A full elongate region 724 may be processed by performing step S1 repeatedly to process the number of sections 730 necessary to fill the elongate region 724. Example geometries of the sections 730 and elongate regions 724 are described in further detail below with reference to **FIG. 13-14.**

**FIG. 11** and **12** depict an example relationship between a geometry of a grid of sub-beams in a multi-beam (defined by grid positions 702 of the sub-beams) and a geometry of sub-beam processed areas 740 obtained by performing the method of steps S1-S5 of **FIG. 9**. Each sub-beam processed area 740 may be formed by an array of the sections 730 comprising rows of sections 730 and columns of sections 730. The array will typically be rectangular or square. The array may have other forms, such as parallelogram or rhombus. Together, the sub-beam processed areas 740 are scanned by different sub-beams and thus define a discontinuously scanned region of the surface of the sample 208. A footprint of the surface of the sample 208 may be considered to be a discontinuously scanned part of the surface of the sample 208.

The example of **FIG. 11** and **12** demonstrates that the symmetry of the grid of sub-beams does not need to be the same as the symmetry of the sub-beam processed areas 740. In the example shown, the sub-beams are provided on a hexagonal grid (i.e., a grid having hexagonal symmetry), while the sub-beam processed areas 740 are rectangular. Continuous coverage of the sample surface parallel to the first direction (horizontally in the orientation depicted) is achieved by arranging for the lengths of the elongate regions 724 to be substantially equal to the pitch 711 of the grid of sub-beams in the first direction (i.e. the width of the tessellating hexagons centered on the grid positions 702). Continuous coverage of the sample surface parallel to the second direction (vertically in the orientation depicted) can be achieved by arranging for the sum of the widths of the sections 730 (and, therefore, of the elongate regions 724) in each column 737 of sections 730 to be substantially equal to a pitch 712 of the grid of sub-beams in the second direction. However, scanning of the sub-beams may be discontinuous so that the continuous coverage is achieved through contiguous coverage by discontinuously scanned sections 730. In practice, it may be necessary to overlap the elongate regions 724 slightly along the columns, in which case the sum of the widths of the elongate regions 724 in each column 737 may need to be correspondingly longer. It may be that less than 100% coverage can be tolerated. For example, gaps of up to a threshold gap, for example up to 100nm may be tolerated in some cases. In such cases, it may be possible for the sum of the widths of the elongate regions 724 in each column 737 to be slightly smaller than the pitch 712.

In a specific example case where the sub-beams are provided in a hexagonal array with 70 micron pitch (and neglecting for simplicity the possibility of overlaps or gaps between sections 730), each sub-beam would be scanned over a rectangular area (defining the sub-beam processed area 740) of $70\mu$m × $60.6\mu$m to scan a continuous area (with the 60.6 arising because

$$0.5 \times \sqrt{3} \times 70 = 60.6)$$ . In an example case where the field of view of an objective lens (which defines the maximum range of relative movement between the multi-beam and the sample surface that the charged particle device can provide at a fixed position of the sample relative to the charged particle device) is about 1 micron, to cover one area of $70\mu$m × $60.6\mu$m would require 60 scans of sections 730 that are $1.01\mu$m wide in each column 737 of sections 730. The length of each section 730 multiplied by the number of columns of sections 730 would be equal to $70\mu$m. Note: in a different arrangement the sub-beams may be provided in an array having a grid of a different shape, for example parallelogram, rhombus, rectangular or square. For each shape of beam arrangement, the sub-beam processed areas 740 may be rectangular.

**FIG. 13** shows schematically how sections 730 of elongate regions 724 can fill a single sub-beam processed area 740. The sections 730 are depicted as contiguous (touching with no overlap or gaps) but, as described above, in practice the sections 730 may be processed such that there are small overlaps and/or gaps between them. The overlaps or gaps can be controlled by controlling the width of the sections 730 (e.g., by varying the distance over which the electrostatic scanning is performed) and/or by controlling the positioning of the sections 730 (e.g., to position the sections 730 closer together to increase an overlap or to position the sections 730 further apart to decrease an overlap or provide a gap between sections 730). The sections 730 are provided in a rectangular array having 7 rows and 3 columns. Each row of three sections 730 fills a single elongate region 724. A single elongate region 724 may correspond to the sub-beam pitch.

The scanning of an elongate region 724 may be achieved with overlaps between the sections 730, at least in the elongate directions of the sections 730, to ensure the elongate regions 724 are a pitch in length. The elongate regions 724 together define the sub-beam processed area 740. The sub-beam processed area 740 is thus comprised of multiple columns of sections 730. The overlaps between sections 730 may be arranged to be the same for all elongate regions 724 scanned at the same time by the different sub-beams of the multi-beam arrangement. An example elongate region 724 is shown in bold and labelled 724. As mentioned above, the extent to which sections 730 overlap (or not) along the columns may be controlled by controlling the widths and/or positions of the sections 730 along the columns.

**FIG. 14** illustrates schematically how steps S1-S5 can be used to process a sub-beam processed area 740 such as that shown in **FIG. 13** with each sub-beam.

Each sub-beam processed area 740 may be processed in its entirety or only partially. For example, during processing of a sub-beam processed area 740 a sub-beam of the multi-beam may be stopped or switched to process a different area of the sample. The sub-beams may be blanked (which can be referred to as 'switched off') during part of the scanning in **FIG. 14.** Methods of the present disclosure may thus be configured to process at least a portion of a sub-beam processed area 740 with each sub-beam. Each sub-beam processed area 740 may comprise an array of sections 730 having rows of sections 730 and columns of sections 730. Each row of sections 730 may define an elongate region 724 as described above (the elongate region 724 may be substantially equal to or smaller than a pitch at the sample surface of the sub-beams in the multi-beam). The processing of at least a portion of the sub-beam processed area 740 comprises processing a plurality of the sections 730.

As described above, in step S1 one section 730 is processed with each sub-beam. The processing of this step S1 is exemplified in **FIG. 14** for one sub-beam (the sub-beam corresponding to the sub-beam processed area 740 shown in **FIG. 13** and **14**) by the horizontal solid arrow labelled S1 pointing to the right in the section 730 positioned in the top-left corner of the array of sections 730.

In step S2, the sample 208 is displaced in a direction oblique or perpendicular to the first direction. The displacement of the sample 208 may be considered as being relative to a path of the multi-beam. In the example of **FIG. 14**, the displacement of the sample 208 causes a center of a field of view of an objective lens to move relative to the sample 208 as indicated by the broken lines labelled S2. In the example of **FIG. 10** and **14**, the field of view of the objective lens is displaced in S2 in a direction perpendicular to the first direction (e.g., vertically downwards in the plane of the page). The corresponding displacement of the sample 208 may be referred to as a step. The sample support (e.g., stage 209) may thus be configured to step the sample 208. The direction of displacement may be referred to as a stepping direction. The movement of the sample surface relative to the multi-beam along path 721 may thus be in a direction orthogonal to the stepping of the stage 209. The distance of displacement of the sample in step S2 after each iteration of step S1 may be such that the plurality of processed sections 730 in each column 737 are partially overlapping (as exemplified in **FIG. 10**), contiguous, or close enough to provide acceptable coverage of the sample surface, for example less than a coverage gap such as 20, 50, 100 or 200 nm, taking into account imperfections. Such overlap may be referred to as stripe overscanning. Stripe overscanning may be achieve by scanning a section 730 so it is broader or by positioning sections 730 closer together. Stripe overscanning may mean that additional sections 730 need to be scanning in each column in order to process the full sub-beam processed area 740. Scanning more sections 730 in each column is undesirable because it decreases throughout.

The distance of displacement of the sample 208 by the sample support (e.g., stage 209) in the direction oblique or perpendicular to the first direction in the successive steps may thus be close to (typically just less than) the maximum range of movement in the direction parallel to the second direction of the multi-beam relative to the sample surface by the charged particle device in step S1 (e.g., a maximum range of electrostatic deflection).

The term overscan refers to scanning a larger area than is nominally necessary to achieve adequate processing (e.g. scanning of a sample surface by a sub-beam) in the absence of scanning imperfections. Overscan can be performed for various different reasons: e.g., to enable data of adjacent scans to be combined together (e.g. stitched together) to form an image of larger area; or to account for alignment error (the location of the region of interest not being known exactly); or for a combination of reasons, some of which may be disclosed herein. In the context of methods of the type described above with reference to **FIG. 9** for example, stripe overscan may be necessary to account for drift in properties of sub-beams or variations in the strengths of sub-beam deflectors. The stripe overscan may be such that sections 730 are arranged to overlap with each other along the column 737 of sections 730. The overlap may be in the range of 5%-10% of the width of the sections 730 for example. For a typical deflection range of 1.0 microns, this would correspond to an overlap in the range of 10-250nm, for example 50nm-100nm. In embodiments where a small gap between the sections 730 is tolerable (e.g., up to a threshold gap, such as up to around 100nm), the sections 730 may be nominally arranged to have an average spacing that is closer than the acceptable gap size to compensate for the imperfections in the scanning process. Thus, the sections 730 are scanned more densely than nominally required to compensate for imperfections.

In step S3, step S1 is repeated to process a section 730 with each sub-beam. The section may be considered to be part of a further elongate region 724 which may adjoin the elongate region 724 of the previously scanned section 730 during step S1. In the example of **FIG. 14**, the repetition of step S1 processes the second section down in a first column 737 of the array (for example the leftmost column as depicted). The second section 730 in descent of the column 737, for example the second section 730 down, is part of the second row. The second row forms the further elongate region 724. The distance of displacement of the sample in step S2 may be such as to include a stripe overscan, as discussed above. Thus, after scanning of a section 730 in step S1 a next section 730 that adjoins the previous scanned section 730 is scanned (in step S3) using the same movements as those used to scan the previous scanned section 730 (because both sections 730 are scanned using the movements defined in step S1).

In step S4, steps S2 and S3 are repeated multiple times to process sections 730 of further respective elongate regions 724 with each sub-beam. Each elongate region 724 corresponds to a different respective row in the array. In the example of **FIG. 14,** the repetition of S2 and S3 processes the 3rd-7th sections 730 in the first column 737 of the array, thereby completing processing of one column 737 in the array. Note in a variation, step S2 moves the sample relative to the path of the sub-beam such that the relative motion of the sample and the sub-beam in step S3 is the same as step S1, so that S3 is an alternative label for S1. That is, instead of moving the sample 208 relative the path of the sub-beam to the adjoining section 730 along the column 737, the sample is additionally moved in the opposite direction of the movement in S1 so that the scanning motion of the sample relative to the beam path is the same for step S3 as for step S1. Similarly step S4 has repeating movements of steps S1 to S3 (or alternatively steps S1 and S2 according the alternative embodiment) because S3 has the same movement as S1).

Step or pitch area overscan (or column area overscan when applied to a column) may be applied in step S4 when scanning the sections 730 which form the column. The pitch area overscan refers to arranging for an overall size of the sub-beam processed area 740 to be larger than is nominally necessary in the absence of imperfections. For example, the size of the sub-beam processed area 740 may be made slightly larger than a pitch of the multi-beam arrangement in a direction parallel to the columns of sections 730 and/or in a direction parallel to the rows of sections 730. The pitch area overscan can be achieved by arranging for sections 730 at the edges of the sub-beam processed area 740 to extend beyond a nominal boundary of the sub-beam processed area 740. This can be achieved by controlling the widths, lengths and/or positions of these sections 730 and/or by adding additional sections 730 in the rows and/or columns. Pitch area overscan can address beam or sample drift during the scanning of a whole sub-beam processed area 740 and/or imperfections in the sub-beam grid. It may be useful for stitching sub-beam processing areas 740 together.

In step S5, steps S1-S4 are repeated to process a series of sections 730 of the elongate regions 724 for each sub-beam. The series of sections that are processed may be referred to as unprocessed regions prior to processing. Each repeat of steps S1-S4 processes a column 737 of sections 730. Each series of unprocessed sections 730 may thus correspond to one column 737 of sections 730. In the example of FIG. 14, the series of unprocessed sections consists of the sections 730 in the middle column 737 of the array. The series of unprocessed sections adjoin, in a direction parallel to the movement in step S 1, a corresponding series of sections 730 of respective elongate regions 724 previously processed by the sub-beam. In the example of FIG. 13, the previously processed sections are the sections 730 in the left column 737 of the array. The sections 730 of the middle column may thus adjoin the sections 730 in the left column in the horizontal direction as depicted.

Step S5 can be performed once or a plurality of times. For example, step S5 may be repeated a number of times between 1 and 9 or a sufficient number of times so that the sections 730 of the sample surface of each elongate region 724 are processed. In some embodiments, S5 is performed enough times that the resulting plurality of processed sections 730 cover the plurality of elongate regions 724. The processed plurality of elongate regions 724 then cover and/or define the sub-beam processed area 740 for each sub-beam. Typically the number of repeats of step S5 is one less than the number of sections 730 in an elongate region 724, or the same as the divisions an elongate region 724 undergoes to define its constituent sections 730. For example, with ten sections 730 per elongate region 724, step S5 is repeated nine times. This corresponds to the number of divisions made to an elongate region 724 to define the ten sections 730. In the example of FIG. 14, step S5 is performed twice because each elongate region 724 contains three of the sections 730. The first performance of S5 processes the middle column 737 of sections 730. The second performance of S5 processes the right column 737 of sections 730. The direction of processing the sections 730 of a respective column 737 may be in the same direction as step S2, for example down the column 737, or it may be in a different direction, for example up the column 737. The direction of processing the sections 730 of a column 737 may be the same or the direction of scanning the sections 730 in different columns may be opposing, for example every alternate or adjoining column 737.

The method of steps S1-S5 can thus be used to process columns of sections 730 in sequence with all of the sections 730 in each column 737 being processed before processing of a subsequent column 737. In other embodiments in which an array of sections 730 are processed, the rows of the sections 730 may alternatively be processed in sequence, with all of the sections 730 of each row being optionally processed before processing of a subsequent row.

As described above, overscanning may be used to compensate for imperfections, including factors that drift over time, such as variations in deflector performance and thermal effects from heating caused by the sub-beams. Overscanning reduces throughput by increasing the total amount of scanning required. The extent of overscanning required depends on the magnitude of imperfections that need to be compensated for by the overscanning. The magnitude of imperfections depends in turn on the delay between processing one section 730 and processing a next section 730. This delay is reduced relative to the case where each elongate region 724 is processed as a whole before moving on to the next elongate region 724 by making the sections 730 smaller than the elongate regions 724. Making the sections 730 smaller means they can be scanned more quickly at the same dose. Smaller sections increases the number of sections per elongate region 724 or across the processed area 740. Processed areas with smaller sections have more columns 737. Reducing the delay between scanning different sections 730 reduces the impact of drift on positioning accuracy of the sample relative to the path of the multi-beam between scanning of the different sections 730. The resulting improvement in positioning accuracy means that less overscan is required to ensure adequate coverage of the sample surface. For example, less overlap may be required between neighbouring sections 730 in a column of sections 730. Reducing the overscan improves throughput by reducing the total amount of scanning that is done. For example, the portion of each sub-beam processed area 740 that is scanned twice is reduced. Where overscanning causes extra sections 730 to be required in columns of the array of sections 730, the number of such extra sections 730 is reduced. Thus, processing the sub-beam processed area 740 in an array of sections having multiple columns (rather than a single column) contributes to an improvement in throughput.

Embodiments of the present disclosure are particularly applicable to the case where an electrostatic deflection range (a maximum range of movement in the direction parallel to the second direction of the multi-beam relative to the sample surface by the column) in step S1 is substantially equal to or less than half (50%) of, optionally less than 10% of, optionally less than 5% of, optionally less than 2% of, optionally less than 1% of, optionally less than 0.5% of, a minimum pitch at the sample surface of the sub-beams in the multi-beam. As described above with reference to **FIG. 11**, the sub-beams in the multi-beam may be provided in a grid defined by grid positions 702. The pitch of the sub-beams may refer to the pitch of the grid positions 702. The sub-beams are therefore arranged to scan within their pitch; that is scanning is non-continuous when scanning a sub-beam further than the multi-beam arrangement. The pitch along different principal axes of the grid may be different. The minimum pitch may be the pitch along the principal axis that has the smallest pitch. Embodiments are thus particularly applicable where the hardware is not capable of scanning a sub-beam over a distance large enough to cover more than half of a pitch without movement of the sample 208 relative to the charged particle device 41, 41', 41". The approach may therefore be applied efficiently to embodiments having an objective lens array assembly such as those described above with reference to **FIG. 3-7**. As mentioned, such devices may have scanning deflectors relatively close to the sample, limiting the electrostatic scan range of their deflectors.

In some embodiments, the method further comprises performing steps S6 and S7 in sequence (S6 followed by S7). In step S6, the sample support is used to displace the sample 208 by a distance equal to at least twice a pitch at the sample surface of the sub-beams in the multi-beam. This displacement may be referred to as a leap displacement. The distance of displacement may be much larger than twice the pitch, optionally many times longer, for example 10 to 100 times the pitch, optionally as large as an overall size of the footprint of the multi-beam on the sample surface.

In step S7, steps S1-S5, optionally steps S1-S6, are repeated from the new location of the sample 208 after the displacement of step S6. Thus, the scanning of the multi-beam in the successive steps (e.g. steps S1-S5) may be performed plural times to process a corresponding plurality of sub-beam processed areas 740 with each sub-beam, and the stage 209 may optionally perform a leap displacement (e.g. step S6) after each performance of the successive steps. The sample 208 is thus moved each time so that a new region of the sample surface is positioned under a multi-beam output region of the charged particle device. The method may be used to process multi-beam sized areas with each performance of steps S1-S5. The multi-beam sized areas can be adjacent to each other to scan a large continuous area; that is a contiguous area of the sample scanned discontinuously by the sub-beams of the multi-beam arrangement. Alternatively, multi-beam sized areas that are separated from each other may be processed. The movement of the sample 208 in S6 may be in the first direction or the second direction. However, the movement can be in any direction to any region of the sample surface.

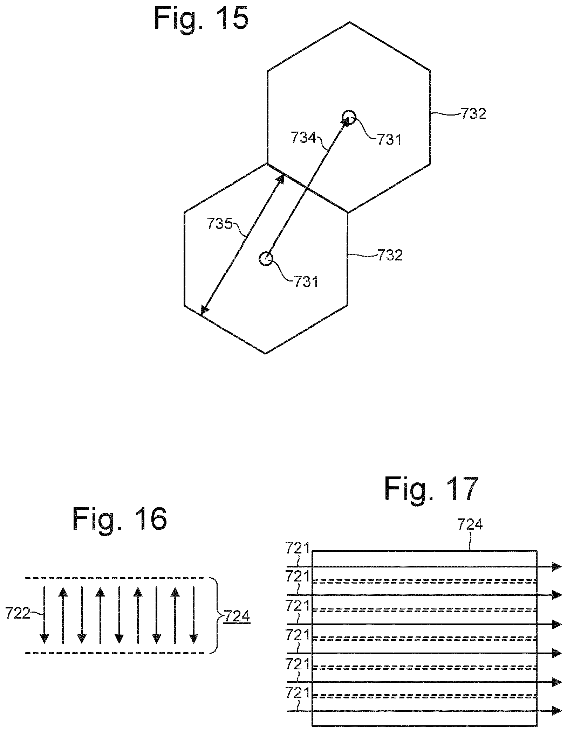

In some embodiments, each sub-beam processes a respective sub-beam processed area 740 and the resulting plurality of sub-beam processed areas 740 overlap and/or are contiguous with respect to each other. A continuous region larger than any individual sub-beam processed area 740 is thus processed between each of the leap displacements. The plurality of sub-beam processed areas 740 forming the continuous region may define a footprint of the charged particle device 41, 41',41". As exemplified in **FIG. 15**, a footprint 732 of the charged particle device may be defined as the smallest bounding box on the sample surface that surrounds all of the sub-beam processed areas 740. Thus, the footprint 732 has an outline or a boundary which corresponds to (e.g., is the same as) an outline of the smallest bounding box on the sample surface that surrounds all of the sub-beam processed areas 740. The sub-beam processed areas 740 surrounded by the smallest bounding box are the sub-beam processed areas 740 formed for a small range of positions (corresponding to the movements of the sample 208 required to perform steps S1-S5) between leap displacements (performances of step S6). The size and shape of the footprint of the charged particle device may be defined by the size and shape of the multi-beam output surface of the charged particle device (e.g., a portion of the objective lens array closest to the sample 208). In some embodiments, the distance of displacement of the sample 208 in step S6 (indicated schematically by the arrow 734 leading from the center 731 of one footprint 732 to the center 731 of another footprint 732) is substantially equal to or greater than a dimension 735 of the footprint parallel to the direction of the movement. The direction of the displacement of the sample 208 in step S6 may be parallel to the first direction (corresponding to the direction of movement of the sample 208 in step S1) or in a different direction. The displacement in step S6 may be configured so that the sub-beam processed areas 740 filling footprints between leap displacements fit together, as exemplified in **FIG. 15**. Thus, one performance of steps S1-S5 may define a first group of sub-beam processed areas 740 (e.g. within the lower-left footprint 732 in **FIG. 15**). Step S7 may subsequently form a second group of sub-beam processed areas 740 (e.g. within the upper-right footprint 732 in **FIG. 15**) that overlaps and/or is contiguous with the first group of sub-beam processed areas 740.

In embodiments described above, the sections 730 in the array of sections 730 are processed column by column. In other embodiments, the sections 730 are processed in a different sequence. For example, in some embodiments, the sections 730 are processed row by row (i.e., processing of each row is completed before starting processing of the next row). For example, processing of all of the sections 730 in the top row in the example configuration of **FIG. 13** may be followed by processing of all of the sections 730 in the next row down. The processing is continued until all of the sub-beam processed area 740 has been processed. In some embodiments, different subsets of the sections 730 are processed using different respective directions of displacement of the sample in steps S1 and S3. This is exemplified in **FIG. 14** where half of the sections 730 are processed with the sample moving to the right in S1 and S3 and half of the sections 730 are processed with the sample moving to the left in S1 and S3. Various other configurations are possible. For example, the sample could be moved in the same direction for all sections 730 in one column and in the opposite direction for all sections 730 in a different column. It is furthermore not necessary for the movement from one section 730 in a column 737 to the next section 730 in a column 737 to be downwards (as depicted in **FIG. 13**). The sections 730 in each column 737 could instead be processed from the bottom to the top. Alternatively, different columns 737 could be processed in different directions. Sections 730 in one column 737 could be processed from the top to the bottom and sections 730 in an adjacent column 737 could be processed from the bottom to the top. In some embodiments, the sections 730 in the array can be processed such that plural but not all sections 730 in one row are processed before processing of plural but not all sections 730 in a different row, such as in an adjacent row. In some embodiments, a first column of sections 730 is processed, a second column of sections 730 is processed directly after the first column of sections 730, and the first column of sections 730 and the second column of sections 730 are not directly adjacent to each other. Thus, a third column of sections 730 may be provided between the first column and the second column and processed at a later time. Similarly, in some embodiments, a first row of sections 730 is processed, a second row of sections 730 is processed directly after the first row of sections 730, and the first row of sections 730 and the second row of sections 730 are not directly adjacent to each other. Thus, a third row of sections 730 may be provided between the first row and the second row and processed at a later time.

In some embodiments, the paths 722 of the movement of the multi-beam relative to the sample 208 by the charged particle device in step S1 are all in the same direction, as exemplified in **FIG. 10**. This approach may promote uniformity of the scanning process from one scan to the next scan and/or may allow errors to be more easily corrected for. For example, in the case where the scans by the charged particle device during step S1 are all performed in the same direction (i.e. stepped) a mismatch in the synchronization between the deflector and a detector may result in a shift of the pattern. Such a shift can be corrected for in downstream processing of the image. However, in the case where the scans by the charged particle device during step S1 are performed in alternating directions a mismatch in the synchronization between the deflector and the detector may result in a blurring of the pattern (as alternating pixel rows of the image are shifted up and down). This blurring is more difficult to correct for. In other embodiments, as exemplified in **FIG. 16**, the scans of the multi-beam over the sample 209 by the charged particle device in step S1 are performed in alternating directions (e.g., in the sequence up-down-up-down-up etc. in the orientation shown in **FIG. 16**). This allows the scan paths to be more continuous. Arranging for the scan paths 722 to be more continuous may reduce bandwidth requirements in comparison to the approach of **FIG. 10**.

In some embodiments, as exemplified in **FIG. 10** and **14,** the movements of the sample 208 in step S1 during the repeated performances of step S1 are performed in alternating directions (e.g., such that paths 721 follow the sequence right-left-right-left-right etc. in the orientation shown in **FIG. 10**). In such an arrangement the direction of sequential paths 721 may be referred to as continuous and meandering. This approach minimizes the overall distance moved by the sample 208. In other embodiments, as exemplified in **FIG. 17**, the movements of the sample 208 in step S1 during the repeated performances of step S1 are all in the same direction. In such arrangement the direction of sequential paths 721 may be referred to as stepped.

As mentioned above, the processing by the sub-beams may cause charged particles to be emitted from the sample 208. The emitted charged particles may be detected and used to determine information about the sample 208. In some embodiments, the method comprises generating an image data set by detecting charged particles emitted from the sample 208 during the processing of the plurality of sections 730. In an embodiment, each image data set represents information about a portion of the sample surface corresponding to a different respective one of the sections 730. In some embodiments, the sample 208 has nominally identical pattern repeat portions at different positions on the sample surface. The method may comprise detecting defects in the sample by comparing image data sets for sections 730 in which the sample has nominally identical patterns. For example, where the nominally identical pattern repeat portions extend over a large portion of the sample surface, image data sets may be compared for sections 730 that are positioned at corresponding positions in different nominally identical pattern repeat portions. The corresponding positions are such that the patterns within the sections 730 would be identical if the nominally identical pattern repeat portions are perfectly identical. The sections 730 may for example be positioned at the same location relative to boundaries of the respective nominally identical pattern repeat portions. For example, a section 730 at the geometrical center of one of the nominally identical pattern repeat portions could be compared to a section 730 at the geometrical center of another of the nominally identical pattern repeat portions. The comparison may be performed using any of the approaches discussed above with reference to **FIG. 8.** The comparison may be performed by a data processing device 500 such as that described above with reference to **FIG. 8.** The comparison may involve using a first subset of the image data sets to generate a reference image (e.g., using the reference image generator 503) and comparing a second subset of the image data with the reference image to detect defects. Different image data sets may be obtained simultaneously or at different times. The image data sets may be of different locations on the sample. The image data sets may comprise each sub-beam processed area 740 sequentially of the different locations.

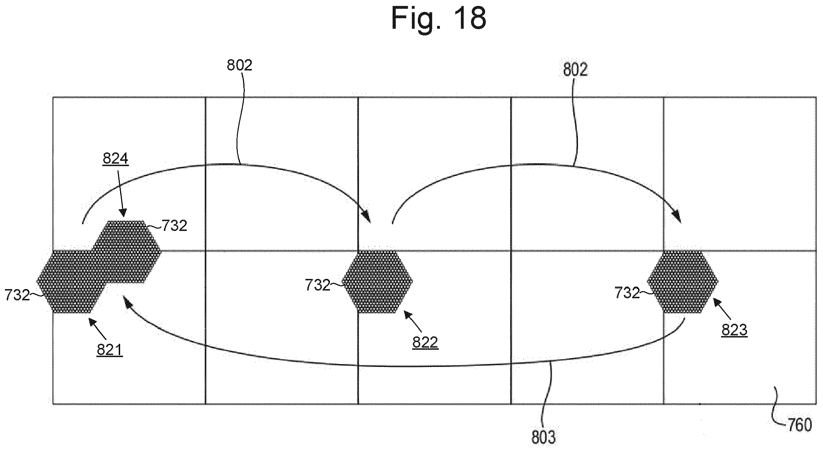

In some embodiments, each sub-beam processes a sub-beam processed area 740 at plural different processing regions on the sample surface. The different processing regions may be different regions within the same die (for example array mode) or regions in different dies (for example die to to die mode). The different processing regions may correspond to different footprints of the surface of the sample 208 that may be spaced apart. **FIG. 18** depicts an example step and scan sequence in an example embodiment in which a rectilinear grid of pattern repeat regions 760 are present on the sample surface. In this case, the different processing regions may be in or overlap with different respective pattern repeat regions 760 or combinations of pattern repeat regions 760. The sub-beams may thus process sub-beam processed areas 740 with the charged particle device predominantly facing one of the pattern repeat regions 760 and then move the sample 208 to a position where the charged particle device is predominantly facing a different one of the pattern repeat regions 760. This may be referred to as a step and scan sequence. In the example shown, the sub-beam processed areas 740 corresponding to each scanning phase are within a hexagonal footprint 732 (corresponding to an example geometry of the multi-beam as described above with reference to **FIG. 15** for example). The example step and scan sequence moves the footprint 732 in sequence from a starting footprint position 821 through footprint positions 822-823 via steps 802. A larger step 803 then brings the footprint 732 back either to a different starting footprint position 824 (as shown in **FIG. 18**), or to the same starting footprint position (not shown), and the sequence can be repeated.

In some embodiments, all of the sections 730 in each sub-beam processed area 740 are processed at each footprint position 821-823. In this case, it may be appropriate for the larger step 803 to bring the footprint 732 back to a different starting footprint position, as exemplified in **FIG. 18** before the sequence is repeated.

In some embodiments, only a subgroup (less than all) of the sections 730 of the sub-beam processed areas 740, for example at least one section 730, are processed at each visit to a footprint position 821-823. The sections 730 may, for example, be processed in groups for each sub-beam. Each group comprises a sub-group of one or more sections 730 in each of two or more different processing regions on the sample 208 (e.g., two or more different nominally identical pattern repeat portions 760, which may or may not be located on different dies). Thus, in the example of **FIG. 18,** a group for one of the sub-beams may comprise a first sub-group of sections 730 (containing one or more sections) within the footprint 732 at footprint position 821, a second subgroup of sections 732 (containing one or more sections) within the footprint 732 at footprint position 822, and a third sub-group of sections 732 (containing one or more sections) within the footprint 732 at footprint position 823. The sub-groups of a group may be processed in sequence before a subsequent group is processed. Image data sets derived from processing of sections 730 in each group can be compared with each other to detect defects in the sample 208. In such embodiments where only a subgroup of sections 730 are processed at each visit to a footprint position 821-823, it may be appropriate for the larger step 803 to bring the footprint 732 back to the same starting footprint position 824. The step and scan sequence can then be repeated with a different subgroup of the sections 730 being processed at each footprint position 821-823.

Any sections 730 or groups of sections 730 that are located at corresponding positions in different nominally identical pattern repeat portions can be compared with each other to detect defects in the sample 208.

Processing only a sub-group of sections 730 at each visit to a footprint position 821-823 (rather than all of the sections 730) may advantageously reduce a delay between processing of sections 730 in different processing regions that are going to be compared with each other to detect defects. Reducing the delay may reduce the chance of sub-beam properties changing between measurements of the respective sections 730, thereby improving accuracy. Reducing the delay may also reduce buffering requirements in the data processing device 500. The buffering may be reduced so that it at least accounts for the movement between two footprints. Such movement may occur after processing of a section 730 in place of a full elongate region 724. Moving the footprint 732 more frequently between different footprint positions 821-823 may also reduce negative effects from heating caused by the multi-beam. The more frequent moving of the footprint 732 spreads heating more evenly over the sample 208. Non-uniform heating causes an expansion that is not common to all sub-beams of the multi-beam. Effects that are not common to all sub-beams cannot be fully corrected by realigning the sample 208. It is therefore particularly desirable to minimize non-uniform heating of the sample 208.

Processing only a sub-group of sections 730 at each visit to a footprint position 821-823, for example only a single section 730, may increase a delay between processing of sections 730 in the same column 737 of sections of a sub-beam processed area 740. For example, if it takes 30s to process a section 730, a delay between the start of processing the section 730 and the start of processing a section 730 below the section 730 in the same column 737 would be about 30s in the case where the sections 730 in a column 737 are processed directly one after the other, but would be 90s (three times longer) in the case where processing is performed following a scheme such as that shown in **FIG. 18**. The methods described above with reference to **FIG. 9-17**, which involve processing sections 730 that are shorter than the scanned elongate region 724, for example shorter than the length of the sub-beam processed area 740, are particularly advantageous in controlling the effects of drift and thereby reducing the need for throughput damaging increases in stripe overscan. The sections 730 may for example be a fraction of a length, or any proportion of the length, such as a third of a length, of the sub-beam processed area 740, as exemplified in **FIG. 13-14**).

Sample alignment operations may be performed periodically to compensate for effects such as heating-induced thermal expansion of the sample 208 during processing by the multi-beam. In some embodiments, methods of the present disclosure thus comprise performing one or more sample alignment operations. In some embodiments, the method comprises performing a sample alignment operation between processing of different sections 730 in an array of sections 730 such as that depicted in **FIG. 13** and **14.** Performing the sample alignment operation between the processing of different sections 730 may reduce a delay between sample alignment operations in comparison to an alternative approach in which alignment operations are only performed after a whole array of sections 730 of a sub-beam processed area has been processed. Reducing the delay may reduce the effects of drift and reduce stripe overscan requirements as discussed above. Each sample alignment operation takes a certain period of time to perform (e.g. 2s). Increases in the overscan requirement (e.g. the stripe overscan requirement with respect to each section and step overscan requirement with respect to the columns and the processed area 740) also increase the amount of time necessary to process the whole sub-beam processed area 740 by increasing the number of sections 730 that need to be processed. A sample alignment operations may appear to add time to complete the alignment, but the total time would be shorter than the time required for the same process in the absence of the sample alignment operation accounting for the time required for additional overscan due to drift and the like. Including sample alignment operations helps reduce the total time for processing of the sample than would otherwise be required accounting for overscan requirements due to drift and the like in the absence of the sample alignment operations. For example, in one example implementation it was found that a column 737 of sections 730 needed to contain 76 sections in the absence of interleaved sample alignment operations, whereas only 64 sections per column were required with interleaved sample alignment operations (due to the reduced stripe overscan requirement). In an example implementation, interleaved sample alignment operations allow a stripe overscan requirement to be reduced from about 20-25% overlap between sections 730 to about 10-15% overlap between sections 730. A balance can therefore be found that improves throughput. In one class of embodiment, an optimum balance is found to be when sample alignment operations are performed every 10-50s, optionally between 20-40s, optionally around 30s.

The sample alignment operation may be performed using any of the various known approaches for aligning a sample 208 relative to a reference. For example, the sample alignment operation may comprise detecting a reference marker on the sample 208, or a reference pattern on the sample 208, and aligning the sample 208 to align the reference marker or reference pattern relative to the charged particle device.

In some embodiments, the sample alignment operations are interleaved between processing of sections 730 such that each of at least a subset of sections 730 have a sample alignment operation performed directly before and directly after processing of the section 730. The number of sample alignment operations may thus be substantially equal to the number of sections 730.

In other embodiments, sample alignment operations are interleaved between processing of groups of two or more sections 730. The sections 730 may be in the same sub-beam processed area 740 or in different sub-beam processed areas 740. The groups may consist of different portions of the column 737 of sections 730 in the array. The groups may consist of different whole columns of sections 730 in the array. The groups may consist of different portions of a row of sections 730 in the array, for example different sections 730 of the same elongate region 724 of the processed area 740. The groups may consist of different whole rows of sections 730 in the array. The groups of two or more sections 730 may each contain the same number of sections 730. The groups may optionally comprise at least 3, at least 5, at least 10, at least 20, or at least 50 sections 730. In an arrangement, at least one alignment operation may occur in scanning the sections 730 of a processed area 740. In an arrangement, an alignment operation may be implemented by a controller when the overscan of a section (i.e. stripe overscan) exceeds an overscan threshold or the overscan of a column of sections or the whole processed area (i.e. step overscan or pitch area overscan) exceeds the overscan threshold and/or a pitch area threshold.

The method comprising steps S1-S5 may be used to implement sample alignment operations interleaved between processing of single sections 730 (groups of one section) in different sub-beam processed areas 740 for example to implement the various and different embodiments described herein. In such an embodiment, step S 1 can be configured to comprise stepping the sample 208 from a position where a first processing region of the sample faces an output portion of the charged particle device to a position where a further processing region faces the output portion of the charged particle device or to each of a plurality of positions where respective further processing regions face the output portion of the charged particle device. The position where the first processing region of the sample faces the output portion of the charged particle device may correspond to the footprint 732 of the charged particle device being at footprint position 821 in **FIG. 18.** The position where a further processing region faces the output portion of the charged particle device may, for example, correspond to the footprint 732 of the charged particle device being at footprint position 822. The plurality of positions where respective further processing regions face the output portion of the charged particle device may correspond, for example, to footprints 732 being at footprint position 822 and 823 respectively in sequence, for example sequential or alternatively in sequence and counter sequence . The method repeats at each position the moving of the sample 208 in a direction parallel to the first direction while using the charged particle device to repeatedly move the multi-beam relative to the sample surface in the direction parallel to the second direction. A section 730 of one of a plurality of elongate regions on the sample surface is thereby processed with each sub-beam in the or each further processing region. The sample alignment operation may, for example, be performed between different performances of step S3 within step S4. Thus, the following sequence may be performed. To begin, a single section 730 (having for example a length less than the size of the corresponding sub-beam processed area) is processed at footprint position 821. Subsequently, a sample alignment operation is performed. Subsequently, a single section 730 is processed at footprint position 822. Subsequently, a sample alignment operation is performed. Subsequently, a single section 730 is processed at footprint position 823. Subsequently, the sample is moved to position the footprint 732 back at footprint position 821.

In some embodiments, an image rendering is derived from a scan of the sample 208. The image comprises a plurality of processed areas 740 arranged in a grid. Each processed area 740 corresponds to a portion of a sample surface scanned by a sub-beam of the multi-beam arrangement. The grid has a dimension corresponding to the pitch of the sub-beams of the multi-beam arrangement. Each processed area 740 comprises an array of sections 730 arranged in rows of the sections 730 and columns of the sections 730. A row of processed sections in the processed area 740 corresponds to an elongate region 724 having an elongate dimension of the width of a processed area 740. Each processed area may have the sections 730 arranged in the same grid. The sections 730 in the elongate region may be dimensioned similarly in the elongate dimension.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array 250 and objective lens array 241, under the control of the controller or control system or control unit. An actuatable component, such as a stage, may be controllable to actuate and thus move relative to another components such as the beam path using one or more controllers, control systems, or control units to control the actuation of the component.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

The methods of the present invention may be performed by computer systems comprising one or more computers. A computer used to implement the invention may comprise one or more processors, including general purpose CPUs, graphical processing units (GPUs), Field Programmable Gate Arrays (FPGAs), Application Specific Integrated Circuits (ASICs) or other specialized processors. As discussed above, in some cases specific types of processor may provide advantages in terms of reduced cost and/or increased processing speed and the method of the invention may be adapted to the use of specific processor types. Certain steps of methods of the present invention involve parallel computations that are apt to be implemented on processers capable of parallel computation, for example GPUs.

The term "image" used herein is intended to refer to any array of values wherein each value relates to a sample of a location and the arrangement of values in the array corresponds to a spatial arrangement of the sampled locations. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

Aspects of the invention are set out in the following numbered clauses.

Clause 1: A method of processing a sample using a multi-beam of sub-beams of charged particles using a charged particle device for projecting the multi-beam onto a sample surface, the method comprising in sequence: (a) move the sample in a direction parallel to a first direction while using the charged particle device to repeatedly move the multi-beam relative to the sample surface in a direction parallel to a second direction, thereby scanning each sub-beam in the direction parallel to the first direction and repeatedly in the direction parallel to the second direction to process a section of one of a plurality of elongate regions on the sample surface with the sub-beam, the distance of movement of the sample in (a) being equal to or less than one half of the pitch at the sample surface of the sub-beams in the multi-beam in the first direction; (b) displace the sample in a direction oblique or perpendicular to the first direction; (c) repeat step (a) to process a section of a further elongate region of the plurality of elongate regions with each sub-beam; (d) repeat steps (b) and (c) multiple times to process sections of further respective elongate regions of the plurality of elongate regions with each sub-beam; and (e) repeat steps (a) to (d) for a series of unprocessed sections of the elongate regions for each sub-beam, the series of unprocessed sections adjoining, in a direction parallel to the movement in step (a), a corresponding series of sections of respective elongate regions previously processed by the sub-beam.

Clause 2: The method of clause 1, wherein a maximum range of the movement in the direction parallel to the second direction of the multi-beam relative to the sample surface by the charged particle device in (a) is substantially equal to or less than half of a minimum pitch at the sample surface of the sub-beams in the multi-beam.

Clause 3: The method of clause 1 or 2, wherein the distance of movement of the sample in (a) is substantially equal to the pitch at the sample surface of the sub-beams in the multi-beam in the first direction divided by a whole number.

Clause 4: The method of any preceding clause, wherein step (e) is performed once or a plurality of times and the resulting plurality of processed sections cover the plurality of elongate regions, the processed plurality of elongate regions defining a sub-beam processed area for each sub-beam.

Clause 5: The method of clause 4, wherein the distance of displacement of the sample in (b) is such that the elongate regions in each sub-beam processed area are partially overlapping with each other, are contiguous with each other, or are separated from each other by less than a threshold gap, for example less than 100nm.

Clause 6: The method of clause 4 or 5, wherein each sub-beam processes a respective sub-beam processed area and the resulting plurality of sub-beam processed areas overlap and/or are contiguous with respect to each other.

Clause 7: The method of any of clauses 4-6, further comprising performing the following steps in sequence after steps (a)-(e): (f) displace the sample by a distance equal to at least twice a pitch at the sample surface of the sub-beams in the multi-beam; and (g) repeat (a)-(e).

Clause 8: The method of clause 7, wherein one performance of (a)-(e) defines a first group of sub-beam processed areas and step (g) forms a second group of sub-beam processed areas that overlaps and/or is contiguous with the first group of sub-beam processed areas.

Clause 9: The method of clause 7 or 8, wherein: where a footprint of the charged particle device is defined as the smallest bounding box on the sample surface that surrounds all of the sub-beam processed areas from a performance of (a)-(e), he distance of displacement of the sample in (f) is substantially equal to or greater than a dimension of the footprint parallel to the direction of the movement.

Clause 10: The method of any of clauses 4-9, wherein step (e) is repeated a number of times between 1 and 9.

Clause 11: The method of any preceding clause, wherein: step (a) further comprises stepping the sample from a position where a first processing region of the sample faces an output portion of the charged particle device to a position where a further processing region faces the output portion of the charged particle device, or to each of a plurality of positions where respective further processing regions face the output portion of the charged particle device, and repeating at each position the moving of the sample in a direction parallel to the first direction while using the charged particle device to repeatedly move the multi-beam relative to the sample surface in the direction parallel to the second direction, thereby processing in the or each further processing region a section of one of a plurality of elongate regions on the sample surface with each sub-beam; and step (b) includes displacing the sample to position the sample back at the position where the first processing region faces the output portion of the charged particle device.

Clause 12: The method of any of clauses 4-11, further comprising performing a sample alignment operation in between processing of different sections of the sample surface.

Clause 13: The method of clause 12, wherein the sample alignment operation is performed in between processing of different sections in the same sub-beam processed area.

Clause 14: The method of clause 12 or 13, wherein the sample alignment operation comprises detecting a reference marker on the sample, or a reference pattern on the sample, and aligning the sample to align the reference marker or reference pattern relative to the charged particle device.

Clause 15: The method of any of clauses 12-14, wherein the sample alignment operation is performed between different performances of step (c) within step (d).

Clause 16: A method of processing a sample using a multi-beam of sub-beams of charged particles using a charged particle device for projecting the multi-beam onto a sample surface, the method comprising: processing at least a portion of a sub-beam processable area with each sub-beam, the sub-beam processable area comprising an array of sections having rows of sections and columns of sections, each row of sections defining an elongate region that is substantially equal to or smaller than a pitch at the sample surface of the sub-beams in the multi-beam, the processing comprising processing a plurality of the sections.

Clause 17: The method of clause 16, further comprising: performing a sample alignment operation between processing of different sections in the array of sections.

Clause 18: The method of clause 17, wherein the sample alignment operation comprises detecting a reference marker on the sample, or a reference pattern on the sample, and aligning the sample to align the reference marker or reference pattern relative to the charged particle device.

Clause 19: The method of clause 17 or 18, wherein sample alignment operations are interleaved between processing of sections such that each of at least a subset of sections have a sample alignment operation performed directly before and directly after processing of the section.

Clause 20: The method of clause 17 or 18, wherein sample alignment operations are interleaved between processing of groups of two or more sections, optionally between groups consisting of different portions of a column of sections in the array, optionally between groups consisting of different whole columns of sections in the array, optionally between groups consisting of different portions of a row of sections in the array, optionally between groups consisting of different whole rows of sections in the array.

Clause 21: The method of any of clauses 16-20, wherein each section is processed by moving the sample in a direction parallel to the rows while using the charged particle device to repeatedly move the multi-beam relative to the sample surface in a direction oblique or perpendicular to the rows, preferably the direction oblique or perpendicular to the rows being a direction parallel to the columns of the array of sections.

Clause 22: The method of any of clauses 16-21, wherein a maximum range of the moving of the multi-beam relative to the sample by the charged particle device during the processing of each section is less than half of a minimum pitch at the sample surface of the sub-beams in the multi-beam, preferably the maximum range being substantially equal to the minimum pitch divided by a whole number.

Clause 23: The method of any of clauses 16-22, wherein the columns of sections are processed in sequence, all the sections of each column being processed before processing of a subsequent column.

Clause 24: The method of any of clauses 16-23, wherein the rows of the sections are processed in sequence, all the sections of each row being processed before processing of a subsequent row.

Clause 25: The method of any of clauses 16-24, wherein the array of sections is a rectangular, square, or parallelogram-shaped array.

Clause 26: The method of any of clauses 16-25, wherein each sub-beam processes a sub-beam processable area at plural different processing regions on the sample surface to define a corresponding plurality of sub-beam processed areas for each sub-beam.

Clause 27: The method of clause 26, wherein: sections are processed in groups for each sub-beam; each group comprises a sub-group of one or more sections in each of two different processing regions; and the sub-groups of a group are processed in sequence before a subsequent group is processed.

Clause 28: The method of clause 27, wherein the plural different processing regions correspond to nominally identical pattern repeat portions.

Clause 29: The method of any of clause 16-28, wherein the method comprises generating an image data set by detecting charged particles emitted from the sample during the processing of the plurality of the sections.

Clause 30: The method of clause 29 further comprising detecting defects in the sample by comparing image data sets for sections having nominally identical patterns.

Clause 31: The method of clause 30, wherein the different image data sets are obtained simultaneously.

Clause 32: The method of clause 30 or 31, wherein the image data sets are of different locations on the sample, comprising each sub beam processable area sequentially of the different locations.

Clause 33: A charged particle assessment system, comprising: a sample support configured to support a sample; a charged particle device configured to project a plurality of sub-beams of charged particles in a multi-beam arrangement onto a portion of a sample surface; a controller configured to control the sample support and the charged particle device to perform the following steps in sequence: (a) move the sample in a direction parallel to a first direction while using the charged particle device to repeatedly move the multi-beam relative to the sample surface in a direction parallel to a second direction, thereby scanning each sub-beam in the direction parallel to the first direction and repeatedly in the direction parallel to the second direction to process a section of one of a plurality of elongate regions on the sample surface with the sub-beam, the distance of movement of the sample in (a) being equal to or less than one half of the pitch at the sample surface of the sub-beams in the multi-beam in the first direction; (b) displace the sample in a direction oblique or perpendicular to the first direction; (c) repeat step (a) to process a section of a further elongate region of the plurality of elongate regions with each sub-beam; (d) repeat steps (b) and (c) multiple times to process sections of further respective elongate regions of the plurality of elongate regions with each sub-beam; and (e) repeat steps (a) to (d) for a series of unprocessed sections of the elongate regions for each sub-beam, the series of unprocessed sections adjoining, in a direction parallel to the movement in step (a), a corresponding series of sections of respective elongate regions previously processed by the sub-beam.

Clause 34. A charged particle assessment system, comprising: a sample support configured to support a sample; a charged particle device configured to project a plurality of sub-beams of charged particles in a multi-beam arrangement onto a portion of a sample surface; and a controller configured to control the sample support and the charged particle device to: a) process at least a portion of a sub-beam processable area with each sub-beam, the sub-beam processable area comprising an array of sections having rows of sections and columns of sections, each row of sections defining an elongate region that is substantially equal to or smaller than a pitch at the sample surface of the sub-beams in the multi-beam, the processing comprising processing a plurality of the sections; b) expose at least a portion of a sub-beam scannable area with each sub-beam, the sub-beam scannable area comprising an array of sections having rows of sections and columns of sections, each row of sections defining an elongate region that is substantially equal to or smaller than a pitch at the sample surface of the sub-beams in the multi-beam, wherein the sample support and the charged particle device are configured to be controlled to expose a plurality of the sections; and/or c) to expose at least a portion of a sub-beam scannable area with each sub-beam, the sub-beam scannable area comprising an array of sections having rows of sections and columns of sections, each row of sections defining an elongate region that is substantially equal to or smaller than a pitch at the sample surface of the sub-beams in the multi-beam; and perform a sample alignment operation between scanning different sections in the array of sections.

Clause 35. An image rendering derived from a scan of a sample, the image comprising a plurality of processed areas arranged in a grid, each processed area corresponding to a portion of a sample surface scanned by a sub-beam of a multi-beam arrangement, the grid having a dimension corresponding to the pitch of the sub-beams of the multi-beam arrangement, each processed area comprising an array of sections arranged in rows of the sections and columns of the sections, a row of processed sections in the processed area corresponding to an elongate region having an elongate dimension of the width of a processed area, desirably each processed area having the sections arranged in the same grid, desirably the sections in the elongate region are dimensioned similarly in the elongate dimension.

Clause 36. A method of processing a sample using a multi-beam of sub-beams of charged particles using a charged particle device for projecting the multi-beam onto a sample surface, the method comprising: using the charged particle device to project a plurality of sub-beams of charged particles in a multi-beam arrangement onto a portion of a sample surface, the portion corresponding to the field of view of the multi-beam arrangement, each sub-beam assigned to a sub-portion of the portion, each sub-portion corresponding to the field of view of the corresponding sub-beam of the multi-beam arrangement, wherein the sub-portion comprises a plurality of elongate regions extending across the field of view in a first direction and together having an area that comprises the area of the sample surface of the sub-portion, each elongate region comprising a plurality of sections arranged within the elongate region, the elongate regions being optionally similarly dimensioned in a direction oblique or perpendicular to the first direction; and controlling a sample support and the charged particle device so that a sub-beam of the multi-beam arrangement scans sections within the respective sub-portion, the scanning of sections comprising: moving the sample in a direction parallel to a first direction and moving the multi-beam relative to the sample surface in a direction parallel to a second direction, preferably angled with respect to the first direction, to scan a section; and scanning a next section that adjoins the previous scanned section using the same movements.

Clause 37. A charged particle assessment system comprising a sample support configured to support a sample; a charged particle device configured to project a plurality of sub-beams of charged particles in a multi-beam arrangement onto a portion of a sample surface, the portion corresponding to the field of view of the multi-beam arrangement, each sub-beam assigned to a sub-portion of the portion, each sub-portion corresponding to the field of view of the corresponding sub-beam of the multi-beam arrangement, wherein the sub-portion comprises a plurality of elongate regions extending across the field of view in a first direction and together having an area that comprises the area of the sample surface of the sub-portion, each elongate region comprising a plurality of sections arranged within the elongate region, the elongate regions being optionally similarly dimensioned in a direction oblique or perpendicular to the first direction; and a controller configured to control the sample support and the charged particle device so that a sub-beam of the multi-beam is controlled to scan sections within the respective sub-portion so that: the sample is moved in a direction parallel to a first direction, the multi-beam is moved relative to the sample surface in a direction parallel to a second direction, preferably angled with respect to the first direction, and after each section is scanned it becomes a previously scanned section; and a next section that adjoins the previous scanned section is scanned using the same movements.

Clause 38. A charged particle assessment system, comprising: a sample support for supporting a sample having a sample surface; and a charged particle device configured to direct a multi-beam of sub-beams of charged particles onto the sample surface, a portion of the sample surface corresponding to a multi-beam output region of the charged particle device facing the sample surface, the system being configured to control the sample support and charged particle device so that the portion is scanned by the sub-beams of the multi-beam, a sub-portion of the portion being assigned to each sub-beam, wherein: the system is configured to control the sample support to displace the sample in a direction oblique or perpendicular to a first direction in successive steps and, at each step, to move the sample in a direction parallel to the first direction so that, at each step, each sub-beam scans over a section of the corresponding sub-portion in a direction parallel to the first direction, wherein the corresponding sub-portion in a direction parallel to the first direction comprises multiple sections; and the system is configured to control the charged particle device to repeatedly scan the multi-beam over the sample surface in a direction parallel to a second direction during the movement of the sample in the direction parallel to the first direction, wherein the system is configured to scan a further section that is either: of the plurality of sections along the sub-portion in the direction parallel to the first direction; or of the following successive step.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A method of processing a sample using a multi-beam of sub-beams of charged particles using a charged particle device for projecting the multi-beam onto a sample surface, the method comprising in sequence:

   (a) move the sample in a direction parallel to a first direction while using the charged particle device to repeatedly move the multi-beam relative to the sample surface in a direction parallel to a second direction, thereby scanning each sub-beam in the direction parallel to the first direction and repeatedly in the direction parallel to the second direction to process a section of one of a plurality of elongate regions on the sample surface with the sub-beam, the distance of movement of the sample in (a) being equal to or less than one half of the pitch at the sample surface of the sub-beams in the multi-beam in the first direction;
   (b) displace the sample in a direction oblique or perpendicular to the first direction;
   (c) repeat step (a) to process a section of a further elongate region of the plurality of elongate regions with each sub-beam;
   (d) repeat steps (b) and (c) multiple times to process sections of further respective elongate regions of the plurality of elongate regions with each sub-beam; and
   (e) repeat steps (a) to (d) for a series of unprocessed sections of the elongate regions for each sub-beam, the series of unprocessed sections adjoining, in a direction parallel to the movement in step (a), a corresponding series of sections of respective elongate regions previously processed by the sub-beam.

2. The method of claim 1, wherein a maximum range of the movement in the direction parallel to the second direction of the multi-beam relative to the sample surface by the charged particle device in (a) is substantially equal to or less than half of a minimum pitch at the sample surface of the sub-beams in the multi-beam.

3. The method of claim 1 or 2, wherein the distance of movement of the sample in (a) is substantially equal to the pitch at the sample surface of the sub-beams in the multi-beam in the first direction divided by a whole number.

4. The method of any preceding claim, wherein step (e) is performed once or a plurality of times and the resulting plurality of processed sections cover the plurality of elongate regions, the processed plurality of elongate regions defining a sub-beam processed area for each sub-beam.

5. The method of claim 4, wherein the distance of displacement of the sample in (b) is such that the elongate regions in each sub-beam processed area are partially overlapping with each other, are contiguous with each other, or are separated from each other by less than a threshold gap.

6. The method of claim 4 or 5, wherein each sub-beam processes a respective sub-beam processed area and the resulting plurality of sub-beam processed areas overlap and/or are contiguous with respect to each other.

7. The method of any of claims 4-6, further comprising performing the following steps in sequence after steps (a)-(e):

   (f) displace the sample by a distance equal to at least twice a pitch at the sample surface of the sub-beams in the multi-beam; and
   (g) repeat (a)-(e).

8. The method of claim 7, wherein one performance of (a)-(e) defines a first group of sub-beam processed areas and step (g) forms a second group of sub-beam processed areas that overlaps and/or is contiguous with the first group of sub-beam processed areas.

9. The method of claim 7 or 8, wherein:

   where a footprint of the charged particle device is defined as the smallest bounding box on the sample surface that surrounds all of the sub-beam processed areas from a performance of (a)-(e),

the distance of displacement of the sample in (f) is substantially equal to or greater than a dimension of the footprint parallel to the direction of the movement.

10. The method of any of claims 4-9, wherein step (e) is repeated a number of times between 1 and 9.

11. The method of any preceding claim, wherein:

step (a) further comprises stepping the sample from a position where a first processing region of the sample faces an output portion of the charged particle device to a position where a further processing region faces the output portion of the charged particle device, or to each of a plurality of positions where respective further processing regions face the output portion of the charged particle device, and repeating at each position the moving of the sample in a direction parallel to the first direction while using the charged particle device to repeatedly move the multi-beam relative to the sample surface in the direction parallel to the second direction, thereby processing in the or each further processing region a section of one of a plurality of elongate regions on the sample surface with each sub-beam; and

step (b) includes displacing the sample to position the sample back at the position where the first processing region faces the output portion of the charged particle device.

12. The method of any of claims 4-11, further comprising performing a sample alignment operation in between processing of different sections of the sample surface.

13. The method of claim 12, wherein the sample alignment operation is performed in between processing of different sections in the same sub-beam processed area.

14. The method of claim 12 or 13, wherein the sample alignment operation comprises detecting a reference marker on the sample, or a reference pattern on the sample, and aligning the sample to align the reference marker or reference pattern relative to the charged particle device.

15. The method of any of claims 12-14, wherein the sample alignment operation is performed between different performances of step (c) within step (d).

# Fig. 1

# Fig. 2

# Fig. 3

Fig. 4

# Fig. 5

# Fig. 6

# Fig. 7

EP 4 199 033 A1

# Fig. 8

36

# Fig. 9

## Fig. 10

## Fig. 11

## Fig. 12

# Fig. 13

740

737        737       724      737

| 730 | 730 | 730 |
|-----|-----|-----|
| 730 | 730 | 730 |
| 730 | 730 | 730 |
| 730 | 730 | 730 |
| 730 | 730 | 730 |
| 730 | 730 | 730 |
| 730 | 730 | 730 |

# Fig. 14

740

S5

| S1 | (a) | (a) |
| S2 | S2 | S2 |
| S3 | S3 | S3 |
| S2 | S2 | S2 |
| S3 | S3 | S3 |
| S2 | S2 | S2 |
| S3 | S3 | S3 |
| S2 | S2 | S2 |
| S3 | S3 | S3 |
| S2 | S2 | S2 |
| S3 | S3 | S3 |
| S2 | S2 | S2 |
| S3 | S3 | S3 |

S4

# Fig. 15

# Fig. 16

# Fig. 17

Fig. 18

Europäisches
Patentamt

European
Patent Office

Office européen
des brevets

# EUROPEAN SEARCH REPORT

Application Number

EP 21 21 6074

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2018/254167 A1 (ZHAO YAN [US] ET AL) 6 September 2018 (2018-09-06) * paragraphs [0081], [0090], [0100], [0132] – [0136]; figures 2,11A,11B * | 1–15 | INV. H01J37/28 H01J37/302 H01J37/317 |
| A | US 2020/203121 A1 (OGASAWARA MUNEHIRO [JP] ET AL) 25 June 2020 (2020-06-25) * paragraphs [0103] – [0107]; figures 16,17 * | 1–15 | |
| A | WO 2019/238553 A1 (ASML NETHERLANDS BV [NL]) 19 December 2019 (2019-12-19) * paragraphs [0098] – [0107]; figures 2,6-13,15-17 * | 1–15 | |
| A | US 2021/005422 A1 (NAKASHIMA KAZUHIRO [JP]) 7 January 2021 (2021-01-07) * paragraphs [0047] – [0050], [0060], [0087] – [0143]; figures 1,3,4A,4B,7,14A-19B * | 1–15 | |

TECHNICAL FIELDS
SEARCHED       (IPC)

H01J

The present search report has been drawn up for all claims

| Place of search | Date of completion of the search | Examiner |
|---|---|---|
| Munich | 31 May 2022 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 21 6074

This annex lists the patent family members relating to the patent documents cited in the above-mentioned European search report.
The members are as contained in the European Patent Office EDP file on
The European Patent Office is in no way liable for these particulars which are merely given for the purpose of information.

31-05-2022

| Patent document cited in search report | | Publication date | Patent family member(s) | | Publication date |
|---|---|---|---|---|---|
| US 2018254167 | A1 | 06-09-2018 | CN | 110770874 A | 07-02-2020 |
| | | | EP | 3590127 A1 | 08-01-2020 |
| | | | JP | 2020511770 A | 16-04-2020 |
| | | | US | 2018254167 A1 | 06-09-2018 |
| | | | WO | 2018160688 A1 | 07-09-2018 |
| US 2020203121 | A1 | 25-06-2020 | JP | 6966255 B2 | 10-11-2021 |
| | | | JP | 2019036403 A | 07-03-2019 |
| | | | US | 2019051487 A1 | 14-02-2019 |
| | | | US | 2020203121 A1 | 25-06-2020 |
| WO 2019238553 | A1 | 19-12-2019 | CN | 112352301 A | 09-02-2021 |
| | | | JP | 2021526716 A | 07-10-2021 |
| | | | KR | 20210008413 A | 21-01-2021 |
| | | | TW | 202001974 A | 01-01-2020 |
| | | | US | 2021217582 A1 | 15-07-2021 |
| | | | WO | 2019238553 A1 | 19-12-2019 |
| US 2021005422 | A1 | 07-01-2021 | JP | 2021009829 A | 28-01-2021 |
| | | | US | 2021005422 A1 | 07-01-2021 |

EPO FORM P0459

For more details about this annex : see Official Journal of the European Patent Office, No. 12/82

**REFERENCES CITED IN THE DESCRIPTION**

**Patent documents cited in the description**

- US 2020118784 A
- US 20200203116 A
- US 20190259570 A
- US 20190259564 A
- EP 1602121 A1
- EP 20184160
- EP 20217152
- EP 2702595 A1
- EP 2715768 A2